(19)

Europäisches
Patentamt
European
Patent Office
Office européen
des brevets

(11) **EP 2 985 915 A1**

(12) **EUROPEAN PATENT APPLICATION**

(43) Date of publication:
**17.02.2016 Bulletin 2016/07**

(51) Int Cl.:
*H03M 5/14* *(2006.01)*

(21) Application number: **14306271.9**

(22) Date of filing: **12.08.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Thomson Licensing
92130 Issy-les-Moulineaux (FR)**

(72) Inventors:
• **Blawat, Meinolf
30659 Hannover (DE)**

• **Huetter, Ingo
30982 Pattensen (DE)**
• **Gaedke, Klaus
30659 Hannover (DE)**
• **Chen, Xiaoming
30165 Hannover (DE)**

(74) Representative: **Rittner, Karsten
Deutsche Thomson OHG
European Patent Operations
Karl-Wiechert-Allee 74
30625 Hannover (DE)**

(54) **Method for generating codes, device for generating code word sequences for nucleic acid storage channel modulation, and computer readable storage medium**

(57)    Codes are generated for code word sequences for nucleic acid storage channel modulation. A plurality of information units of a first length and a plurality of quaternary code words of a second length are provided (31, 32). The amount of code words is at least twice the amount of information units and the plurality of quaternary code words comprises no code word where the last three code symbols are identical and no code word where the first two code symbols are identical. The code words are distributed (33) to at least a first and a second code and the information units are mapped (35) to the code words of the first code and of the second code. A device (40) for generating code word sequences for nucleic acid channel modulation is used to generate at least one code word sequence by concatenating code words selected from the different codes.

Fig. 3

**Description**

**FIELD**

A method for generating codes and a device for generating code word sequences are presented. In particular, the present disclosure relates to a method for generating codes for nucleic acid storage and to a device for generating code word sequences for nucleic acid storage channel modulation, suitable for encoding of information for storage in synthetic nucleic acid strands, such as DNA or RNA oligos, and to a corresponding computer readable storage medium.

**BACKGROUND**

A nucleic acid is a polymeric macromolecule and consists of a sequence of monomers known as nucleotides. A nucleotide consists of a sugar component, a phosphate group and a nitrogenous base or nucleobase. Nucleic acid molecules where the sugar component of the nucleotides is deoxyribose are DNA (deoxyribonucleic acid) molecules, whereas nucleic acid molecules where the sugar component of the nucleotides is ribose are referred to as RNA (ribonucleic acid) molecules. DNA and RNA are the biochemical storage molecules of genetic information appearing in living organisms.

Nucleic acid molecules are assembled as chains or strands of nucleotides. For instance, RNA molecules are single helical nucleic strands, while DNA double helix molecules are formed out of two antiparallel nucleic strands. In contrast to RNA molecules, DNA molecules are more robust to biological, biochemical and biophysical stress, like enzymes, acids and heat. Nucleic acid molecules can be generated artificially and their chain structure can be used for encoding any kind of user data. For storing data in synthesized, i.e. artificially created, DNA or RNA, usually comparably short DNA or RNA fragments (oligonucleotides, short: oligos) are generated. With these nucleic acid oligos, a data storage system can be realized wherein data are stored in nucleic acid molecules. The synthesized nucleic acid molecules carry the information encoded by the succession of the different nucleotides forming the nucleic acid molecules. Each of the synthesized nucleic acid molecules consists of a sequence or chain of nucleotides generated by a biological, biochemical and/or biophysical process using a synthesizer and represents an oligo or nucleic acid fragment wherein the sequence or chain of the nucleotides encodes a code word sequence corresponding to a set of information units, e.g., sets of information bits, which represent user data. For example, in a DNA storage system, short DNA fragments are generated.

DNA storage has been investigated in "Next-generation digital information storage", Church et al., Science 337, 1628, 2012, and in "Towards practical, high-capacity, low-maintenance information storage in synthesized DNA", Goldman et al., Nature, vol. 494, 2013.

Nearly arbitrary series of nucleotides can be generated with biochemical synthesizers. These series of nucleotides are also referred to as oligonucleotides or oligos. In this context, the terms "nucleic acid fragment", "oligonucleotide" and "oligo" are used interchangeably and refer to a synthesized nucleic acid strand, i.e. a synthesized series of nucleotides.

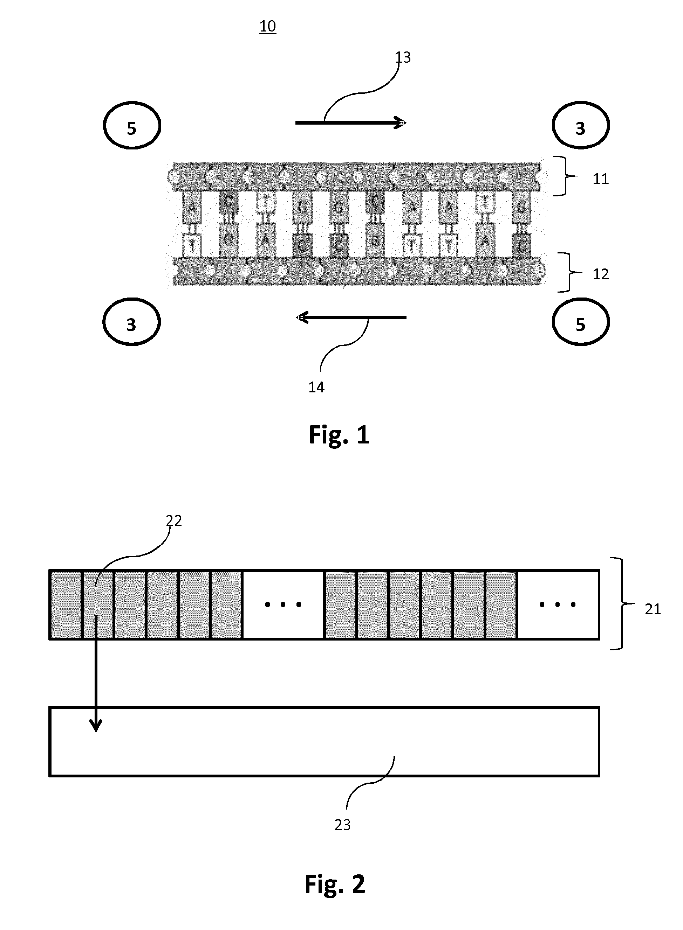

As schematically illustrated in Fig. 1, DNA molecules consist of two strands consisting of a series of four different molecules bonded together, similar to the structure of a common ladder. The schematically shown fragment of a DNA molecule 10 contains two strands 11, 12 which may be regarded as the ladder-bars while the different molecules bonded together may be regarded as the ladder-steps.

DNA strands are built from four different nucleotides identified by their respective nucleobases or nitrogenous bases, namely, Adenine, Thymine, Cytosine and Guanine, which are denoted shortly as A, T, C and G, respectively, as indicated in Fig. 1. As another example, RNA strands also consist of four different nucleotides identified by their respective nucleobases, namely, Adenine, Uracil, Cytosine and Guanine, which are denoted shortly as A, U, C and G, respectively.

Each of the DNA ladder-steps is formed by pairs of the four molecules while only two combinations of such base pairs occur. Guanine goes together with Cytosine (G-C), while Adenine connects with Thymine (A-T). In this context, A and T, as well as C and G, are called complementary. Guanine, Adenine, Thymine, and Cytosine are the nucleobases of the nucleotides, while their connections are addressed as base pairs. In Fig. 1, an example of a DNA molecule 10 is shown, which is a series of nucleotides bonded to the two strands 11, 12. Due to biochemical reasons, DNA strands have a predominant direction how they are read or biochemically interpreted. As shown in Fig. 1, this predominant direction is commonly indicated with '5' at the starting edge and '3' at the ending edge. Further, the predominant direction of strand 11 is indicated by arrow 13, whereas the predominant direction of strand 12 indicated by arrow 14.

The predominant direction of DNA strands allows to assign logically to each base pair of a strand a bit of information. For example, logical values can be assigned to the four nucleotides, identified by their nucleobases, as follows: 0 to G, 1 to A, 2 to T, and 3 to C. Since arbitrary series of nucleotides can be synthesized any digital information can be stored in DNA strands. The data can be any kind of sequential digital data to be stored, e.g., sequences of quaternary code symbols, corresponding to digitally, for example binary, encoded information, such as textual, image, audio or video data. Due to the limited oligo length, the data is usually distributed to multiple oligos.

The oligos can be stored, for example as solid matter or dissolved in a liquid, in a nucleic acid storage container, and the data can be recovered from the oligos by reading the sequence of nucleotides using a biological, biochemical and/or biophysical sequencer.

Synthesizers can produce oligos with a low error rate only of a certain length. For lengths that go beyond, the error rates increase clearly. For example, some synthesizers may produce oligos having a length of up to 350 nucleotides. The possible oligo lengths depend on the working mechanism of the deployed synthesizer. As schematically illustrated in Fig. 2, data to be stored 21 consequently is cut into snippets or portions, while each snippet 22 is logically assigned to an oligo 23 of a predefined length, which carries the data contained in the snippet. Each oligo is identified by a unique identifier, index or address, respectively, so that the data snippets can be recombined in the right order when recovering the stored information.

In principle each nucleotide in an oligo can represent four numbers or code symbols, as each single nucleotide of an oligo can be considered innately as a quaternary storage cell. In order to assign arbitrary data to a set of oligos, for example a code look-up table or code generator is applied. Such a processing module can be regarded as a dedicated channel modulation.

In signal processing, the user data to be stored or transmitted is provided as binary digital data. The smallest unity is 1 bit of data, while for example commonly 8 bits of data are referred to as 1 byte of data. In order to store data in DNA the bits are assigned to oligos.

Without loss of generality, as an example, in the following byte wise data processing is assumed. An information unit carrying a portion of user data can be defined according to eq. 1:

$$byte\ b = (b_0, b_1, b_2, b_3, b_4, b_5, b_6, b_7), while\ bit\ b_i \in \{0,1\}, 0 \le i \le 7 \ \text{(eq. 1)}$$

An oligo can be defined according to eq. 2:

$$oligo\ o = (n_0, n_1, n_2, n_3, \cdots, n_{N-1}), N\ nucleotides\ n_j \in \{A, C, G, T\}, 0 \le j \le N-1$$

$$\text{(eq.2)}$$

Therefore, data assignment to oligos can be represented as shown in eq. 3:

$$byte\ series = (b_0, b_1, b_2, \cdots, b_{B-1}) \xrightarrow{mapping} (n_0, n_1, n_2, n_3, \cdots, n_{N-1}) = oligo;$$

$$byte\ b_i, 0 \le i \le B-1; nucleotide\ n_j, 0 \le j \le N-1 \ \textbf{(eq. 3)}$$

Biological, biochemical and biophysical processes, such as synthesizers, amplifiers and sequencers may not always work correctly. In order to improve reliability of the processes when storing arbitrary data in nucleic acid molecules, at least two constraints may be considered by the used channel modulation:

According to the run-length constraint, the data representing oligos should avoid to contain sections of nucleotides of the same kind that exceed a certain length n, as cascades or sequences of identical nucleotides may reduce sequencing accuracy if the run length exceeds n. Such an oligo section is called homopolymer run-length n. In the following a definition of an oligo with homopolymer run-length of R is given (eq. 4):

$$oligo\ o = \left(n_0, n_1, \cdots, n_j, n_{j+1}, \cdots n_{j+R-1}, \cdots, n_N\right), N\ nucleotides\ n_j \in \{A, C, G, T\},$$

$$0 \le j \le N-1, with\ n_j = n_{j+1} = \cdots = n_{j+R-1}\ run\ length\ R \quad \text{(eq. 4)}$$

According to the constraint of self-reverse complementarity, the data representing oligos may not have sections of self-reverse complementary sequences of nucleotides that exceed a certain length. Long self-reverse complementary sequences may not be readily sequenced which hinders correct decoding of the information encoded in the oligo.

Two sequences of nucleotides are considered "reverse complementary" to each other, if an antiparallel alignment of the nucleotide sequences results in the nucleobases at each position being complementary to their counterparts. Reverse complementarity does not only occur between separate strands of DNA or RNA. It is also possible for a sequence of nucleotides to have internal self-reverse complementarity.

In the following, definitions for a self-reverse complementary oligo (eq. 5), a section of an oligo (eq. 6) and a self-reverse complementary section of an oligo (eq. 7) are given:

$$nucleotide: n \in \{A, C, T, G\}$$

$$oligo: o = (n_0, n_1, n_2, \ldots, n_{N-1}) \; with \; N \; nucleotides$$

$$complementary \; nucleotide: \overline{n} \; for \; n \in \{A, C, T, G\}, while \; \overline{A} = T, \overline{C} = G$$

$$complementary \; oligo: \overline{o} = (\overline{n_1}, \overline{n_2}, \overline{n_3}, \ldots, \overline{n_{N-1}}) \; with \; N \; nucleotides$$

$$reverse \; oligo: \tilde{o} = (n_{N-1}, n_{N-2}, n_{N-3}, \ldots, n_0) \; with \; N \; nucleotides$$

$$self \; reverse \; complementary \; oligo: o = \overline{\tilde{o}} \; with$$

$$(n_0, n_1, n_2, \cdots, n_{N-1}) = (\overline{n_{N-1}}, \overline{n_{N-2}}, \overline{n_{N-2}}, \ldots, \overline{n_0}), \; while \; n_j = \overline{n_{N-j}}, \; N - 1 \geq j \geq 0 \; (\mathrm{eq}.5)$$

$$oligo \; section: o(i:j) = (n_{i,} n_{i+1} \ldots, n_j), 0 \leq i \leq j \leq N - 1 \quad (\mathrm{eq}. \; 6)$$

$$self \; reverse \; complementary \; oligo \; section: o(i:j) = \overline{\widetilde{o(i:j)}} \; with$$

$$(n_i, n_{i+1}, n_{i+2}, \cdots, n_j) = (\overline{n_j}, \overline{n_{j-1}}, \ldots, \overline{n_i}), \; while \; n_i = \overline{n_{j-i}}, 0 \leq i \leq j \leq N - 1 \; (\mathrm{eq}. \; 7)$$

Beside the aforementioned constraints, an efficient channel modulation should be adapted to the channel characteristics. For example, the modulation should exploit the channel bandwidth as far as possible.

Therefore, a channel modulation for storing data in nucleic acid molecules should be used that allows encoding of the data at a high coding efficiency while having a reduced probability of incorrect decoding.

SUMMARY

According to an aspect of the invention, a method for generating codes for nucleic acid storage comprises

- providing a plurality of information units of a first predefined length, the plurality of information units comprising a first amount of information units;
- providing a plurality of quaternary code words of a second predefined length, the plurality of quaternary code words comprising a second amount of code words, wherein the second amount is at least twice as high as the first amount and the plurality of quaternary code words comprises no code word where

the last three code symbols are identical and no code word where the first two code symbols are identical;

- distributing the plurality of code words to at least a first code and a second code; and
- mapping said information units at least to the code words of the first code and of the second code.

According to another aspect of the invention, a device for generating code word sequences for nucleic acid storage channel modulation comprises

- a code generator unit configured to generate at least a first code book and a second code book, the first code book and the second code book comprising a complete mapping of a plurality of information units of a first predefined length to corresponding quaternary code words of a second predefined length of the first code book and of the second code book, wherein
none of the code words belongs to the first and also to the second code book,
none of the code books comprises a code word where the last three code symbols are identical, and
none of the code books comprises a code word where the first two code symbols are identical; and

- a code word sequence generator unit configured to receive user data encoded using the plurality of information units, to map the information units encoding the user data to corresponding code words selected from at least one of the first code book and the second code book, and
to generate at least one code word sequence by concatenating said selected corresponding code words.

Accordingly, a computer readable storage medium has stored therein instructions enabling generation of codes for nucleic acid storage, which, when executed by a computer, cause the computer to:

- provide a plurality of information units of a first predefined length, the plurality of information units comprising a first amount of information units;
- provide a plurality of quaternary code words of a second predefined length, the plurality of quaternary code words comprising a second amount of code words, wherein the second amount is at least twice as high as the first amount and the plurality of quaternary code words comprises no code word where the last three code symbols are identical and no code word where the first two code symbols are identical;
- distribute the plurality of code words to at least a first code and a second code; and
- map said information units at least to the code words of the first code and of the second code.

The computer readable storage medium has stored therein instructions which, when executed by a computer, cause the computer to perform steps of the described method. Further, a computer readable storage medium has stored therein instructions which, when executed by a computer, cause the computer to make available functionalities of the described device.

The first predefined length refers to the number of bits, i.e. code symbols or data bits contained in an information unit, i.e. in a source code word. In an embodiment the first predefined length equals eight. In other words, the information unit corresponds to a byte. However, the data bits to be stored can be divided as appropriate for applied signal processing modules. For instance, in another embodiment, sets of 4 bits instead of bytes correspond to an information unit.

The second predefined length refers to the number of quaternary code symbols of a code word, i.e. of a target code word to be encoded in a sequence of nucleotides. In an embodiment the second predefined length equals five, i.e. a 5-tuple corresponds to a code word. For example, this may be the case, if this first predefined length equals eight.

In other embodiments, the first predefined length and/or the second predefined length can be set to different values, given that the chosen values allow compliance with the constraint according to which the second amount of code words is at least twice as high as the first amount of information units.

"Distributing the plurality of code words to at least a first code and a second code", in other words, refers to dividing the plurality of code words into at least a first subset and a second subset corresponding to a first code and a second code.

The term "mapping the first information units to at least the code words of the first code and of the second code" comprises that there are different corresponding code words at least in the first code and in the second code for each of the information units. The first code and the second code are generated such that none of the code words belongs to more than one of the codes, and each of the two codes is capable of completely encoding the plurality of information units.

In an embodiment, "providing" a plurality of information units or a plurality of code words refers to generating the information units and/or the code words, for example by a processing device. In another embodiment, they are, for example, pre-generated and provided with an appropriate mapping in a code book table stored in a memory device.

The code books may be generated according to any embodiment of the method for generating code words. In an embodiment the term "code word generator unit" refers, for example, to a processing device, dedicated circuitry, or to functionality provided by a processing device, for example connected to a memory device. In another embodiment the term "code word generator unit" refers to, for example, a table or multiple tables containing the code books, wherein the table is provided being stored in at least one memory device or other storage medium. The table is generated according to an embodiment of the method for generating code words.

The solution according to the aspect of the invention provides a channel modulation scheme, suitable for code book generation, e.g. for DNA storage, that is capable to prevent in data representing oligos sections of homopolymer run-length of nucleotides as well as sections of self-reverse complementary nucleotides both exceeding a certain corresponding length. For code words of length 5, run-lengths of more than three identical code symbols, respectively nucleotides, are avoided. According to the other aspect of the invention, the code books generated according to the presented scheme are used for generating code word sequences suitable for synthesizing nucleic acid molecules containing corresponding sequences of nucleotides. The coding scheme is applicable to arranging information units suitably to be stored in nucleic acid fragments while being decodable at a reduced error probability.

The provided solution at least has the effect that symbol errors in code words will at most lead to infected decoded information units of a certain restricted size, for example only two neighboring bits. The reliability of the information units retrieved from sequenced oligos is improved, allowing provision of a reliable system for storing information in nucleic acid molecules, for example for archiving purposes.

In one embodiment the second predefined length is set to equal 5 quaternary code symbols, and the providing of a plurality of quaternary code words comprises providing only different code words of the second predefined length where the second code symbol, the fourth code symbol and the fifth code symbol are set to assume any quaternary value and the first code symbol and the third code symbol are selected such that no code word is provided where the last three code symbols are identical and no code word is provided where the first two code symbols are identical. In other words, the fourth and the fifth code symbols can be identical, but do not have to be. The second code symbol can assume any value, i.e. any of the four possible values of a quaternary code symbol. The first and the third code symbol are then selected such that no code word is provided where the third, fourth and fifth code symbols are identical and no code word is provided where the first and the second code symbols are identical. In this context, the terms "first", "second", "third", "fourth" and "fifth" refer to the actual position of the corresponding quaternary code symbol within the particular code word, i.e. within the sequence of five consecutive code symbols.

Unlike the described coding scheme, the simplest way to assign a data byte to a series of nucleotides wherein 4 values can be assigned to one of the nucleotide, would be to divide a byte into bit pairs of 2 bits each and then mapping the resulting 4 bit pairs of a byte to 4 consecutive nucleotides, or in other words to a tuple of 4 nucleotides $(Nt_4)$, as shown in eq. 8:

$$byte\ b = \{(b_0, b_1), (b_2, b_3), (b_4, b_5), (b_6, b_7)\} \xrightarrow{mapping} (n_0, n_1, n_2, n_3) = Nt_4,$$

$$while\ nucleotide\ n_j \in \{A, C, G, T\}, 0 \leq j < 4 \quad (\text{eq.8})$$

However, in the example shown above, the data to be stored are simply mapped to $Nt_4$ tuples of nucleotides, and the run-length as well as the self-reverse complementarity constraint cannot be met. Another disadvantage of the simple data mapping would be that if one code symbol or, respectively, nucleotide of a $Nt_4$ tuple is in error, cases can be identified where more than 2 bits are infected. To the contrary, according to the embodiment, a bit-to-nucleotide mapping scheme is shown, or in other words code tables, ensuring that at most only 2 bits are infected and that both constraints are met. In other words, the generated code books are capable of preventing in data representing oligos sections of homopolymer run-length of nucleotides as well as sections of self-reverse complementary nucleotides both exceeding a certain corresponding length, while at the same time ensuring that at most only 2 bits are infected.

As an example, the plurality of quaternary code words is provided by generating code words where the fourth code symbol and the fifth code symbol are repeatedly set to assume all possible value combinations until twice the first amount of code words is generated, wherein the second code symbol is repeatedly set to assume all possible values, and the first code symbol and the third code symbol are selected from a table comprising 16 different value combinations of the first and the third code symbol.

In Table A an example of a table for assigning the seventh bits $b_6$ and the eighth bit $b_7$ of a byte of an information unit to the first code symbol corresponding to nucleotide $nt_0$ and the third code symbol corresponding to nucleotide $nt_2$ is shown:

| $b_6$ | $b_7$ | $nt_0$ | $nt_2$ | $nt_0$ | $nt_2$ | $nt_0$ | $nt_2$ | $nt_0$ | $nt_2$ |
|---|---|---|---|---|---|---|---|---|---|
| 0 | 0 | A | A | C | C | G | G | T | T |
| 0 | 1 | A | C | C | G | G | T | T | A |
| 1 | 0 | A | G | C | T | G | A | T | C |
| 1 | 1 | A | T | C | A | G | C | T | G |

(Table A)

A, C, G and T refer to quaternary code symbols.

The selection is carried out such that the first and the second code symbol remain different, and at least one of the third, fourth and fifth code symbol differs from the other two.

In one embodiment remaining code words not assigned to the first code or to the second code are distributed to a third code and at least a subset of said information units is mapped to the code words of said third code. In other words, remaining valid code words are used to generate a third code which can, but does not have to be complete. For example, an incomplete third code is generated if less valid code words remain than required to encode each of the information units.

In one embodiment of the device for generating code word sequences for nucleic acid storage channel modulation, the device comprises a synthesizer unit configured to synthesize at least one nucleic acid molecule containing a segment wherein a sequence of nucleotides is arranged to correspond to the at least one code word sequence. The device for generating code word sequences contains or is contained in a sequencer unit, device or apparatus. Alternatively, the device for generating the code word sequences is connected to the synthesizer unit via an interface.

In one embodiment the code word sequence generator unit is configured to map the information units encoding the user data to corresponding code words alternately selected from the first code book and the second code book. For this, the code word sequence generator unit is connected to request code words from the code generator unit, respectively read the table having stored therein the code books and receive at least the requested code words. This alternating selection allows generation of a code word sequences wherein self-reverse complementary segments will be shorter than the length of two code words.

In one embodiment the code word sequence generator unit is configured to remove a most recently appended code word from said at least one code word sequence and append the corresponding code word of the other of the first code book and the second code book, if said at least one code word sequence comprises a self-reverse complementary section having a length of at least twice the second predefined length.

In one embodiment the code word generator unit is configured to additionally generate at least a third code book, the third code book comprising a mapping of at least a subset of the plurality of information units to corresponding code words of the third code book, wherein

none of the code words of the third code book belongs to the first and the second code book,

the third code book does not comprise a code word where the last three code symbols are identical, and

the third code book does not comprise a code word where the first two code symbols are identical. The code word generator unit is configured to generate the third code book (which may be incomplete), or, respectively, the table of modulation codes is additionally partitioned into at least a third code book.

As an example, the code word sequence generator unit is further configured to remove the most recently appended code word from said at least one code word sequence and append the corresponding code word of the third code book, if said at least one code word sequence comprises a self-reverse complementary section having a length of at least twice the second predefined length, after replacing the most recently appended code word by the corresponding code word of the first code book or of the second code book the at least one code word sequence still comprises such a section and said third code book comprises a corresponding code word. In this example, code words of the third code book are used, if the code word sequence generator unit is unable to generate a sequence that meets the constraints by appending a code word of the first or of the second code. In another embodiment, code words of the first, second and third code books are regularly used alternatingly.

While not explicitly described, the present embodiments may be employed in any combination or sub-combination.

BRIEF DESCRIPTION OF THE DRAWINGS

Fig. 1    schematically illustrates a structure of a fragment of a DNA molecule;

Fig. 2    schematically illustrates a principle of data assignment to oligos to be used for DNA data storage;

Fig. 3    schematically illustrates a method for generating codes for nucleic acid storage according to an embodiment of the invention; and

Fig. 4    schematically illustrates a device for generating code word sequences for nucleic acid storage channel modulation according to another embodiment of the invention.

DETAILED DESCRIPTION OF EMBODIMENTS

For a better understanding, the invention will now be explained in more detail in the following description with reference to the drawings. It is understood that the invention is not limited to these exemplary embodiments and that specified features can also expediently be combined and/or modified without departing from the scope of the present invention as defined in the appended claims.

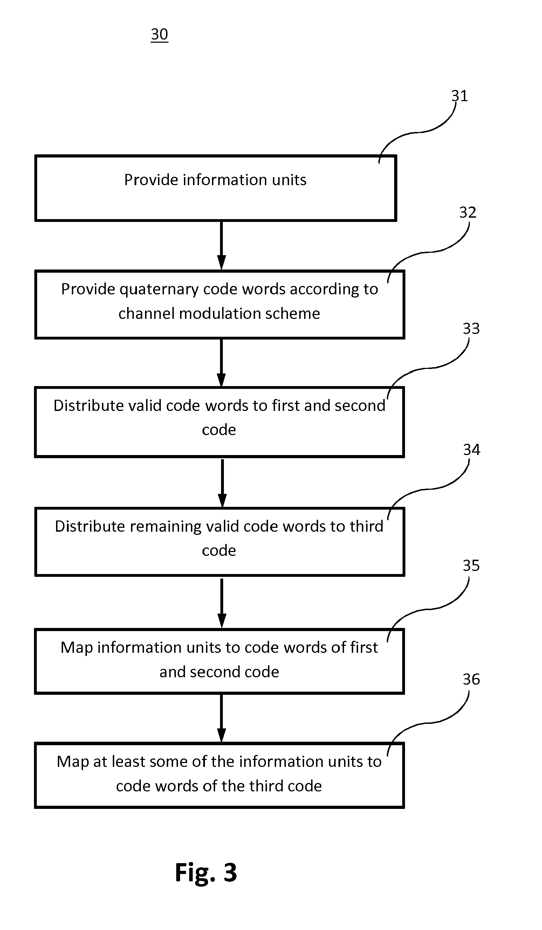

Referring to Fig. 3, a method 30 for generating codes for nucleic acid storage according to an embodiment of the invention is schematically illustrated. The method 30 comprises providing 31 a plurality of information units of a first predefined length. The plurality of information units comprises or consists of a first amount of information units. This first amount depends on the first predefined length by which the space of different information units is determined. In the example shown below the first predefined length is set to eight, resulting in byte wise portioned information units.

Further, the method comprises providing 32 a plurality of quaternary code words of a second predefined length. In the example shown below the second predefined length is set to five, resulting in a code word space of 1024 possible code words. The plurality of quaternary code words comprises or consists of a second amount of code words. The second amount is at least twice as high as the first amount to allow generation of at least two separate codes capable of completely encoding the information units. The plurality of quaternary code words is generated according to a channel modulation scheme, such that it comprises no code word where the last three code symbols are identical and no code word where the first two code symbols are identical, e.g. to satisfy the run-length constraint.

The plurality of code words is then distributed 33 to at least a first code and a second code and the information units are completely mapped 35 at least to the code words of the first code and of the second code. Here, a data byte is assigned to a tuple of 5 code symbols corresponding to 5 nucleotides ($Nt_5$-Tuple). The term "tuple" is used to refer to an ordered list of elements, such as a sequence of code symbols. The $Nt_5$-Tuples are the code words of a coding table; they span in total a space of $4^5 = 1024$ code words, if all possible code words, i.e. valid as well as invalid code words, are counted. The concatenation of $Nt_5$-tuples representing data bytes to be stored is then used to form code word sequences and synthesize oligos from. As an example, see the oligo with N nucleotides shown in eq. 9:

$$byte\ b = (b_0, b_1, b_2, b_3, b_4, b_5, b_6, b_7), while\ b_i \in \{0,1\}, 0 \leq i \leq 7$$

$$Nt_5 = (n_0, n_1, n_2, n_3, n_4), while\ n_j \in \{A, C, G, T\}, 0 \leq j \leq 4$$

$$byte\ b \xrightarrow{mapping} Nt_5$$

$$oligo\ O = (Nt_{5,0}, Nt_{5,1}, Nt_{5,2}, \dots, Nt_{5,j}, \dots, Nt_{5,N-1}), 0 \leq j \leq N-1 \quad (\text{eq. 9})$$

In order to unambiguously code all values a data byte can assume, at least $2^8 = 256$ code words are needed. In purely mathematical terms $Nt_5$ tuples span 4 code tables of 256 code words each. However, the constraints that have to be met limit the number of possible code words, as shown in the following example: If a certain byte is mapped to the $Nt_5$-tuple *(A,A,A,A,A),* then the run-length constraint would be violated, depending on the data to be stored.

To meet the constraints of the channel modulation, the following design rules are followed: Design rule to limit run-lengths of nucleotides of the same type: Only the last three nucleotides of an $Nt_5$-tuple must never be of the same type. Further, the first two nucleotides of an $Nt_5$-tuple must be never of the same type. Design rule to minimize self-reverse complementary series of nucleotides: The number of $Nt_5$-tuple code words and their possible combinations to represent a data byte are selected to be as high as possible.

Based on the design rules, at least the first code and the second code corresponding to two complete code-tables meeting all code table constraints can be found. Code words that meet the code table design constraints are called valid code words, according to which the rest of the $Nt_5$-tuples are invalid code words. According to the example embodiment, code words have a second predefined length of five code symbols and both code tables together comprise 512 code words out of the set of 1024 code words, which can be defined by $Nt_5$-tuples.

Still referring to Fig. 3, according to an embodiment, the method can additionally comprise distributing 34 remaining code words, i.e. remaining valid code words, not assigned to the first code or to the second code to a third code and mapping 36 at least a subset of said information units to the code words of the third code.

With the remaining code words, i.e. after distributing 512 valid code words to the first and the second code, only a further third incomplete code table can be defined comprising 208 valid code words, if the number of $Nt_5$-tuple code words and their possible combinations to represent a data byte are selected to be as high as possible. However, this third incomplete code table increases the number of $Nt_5$-tuple code words and their possible combinations to represent a data byte significantly.

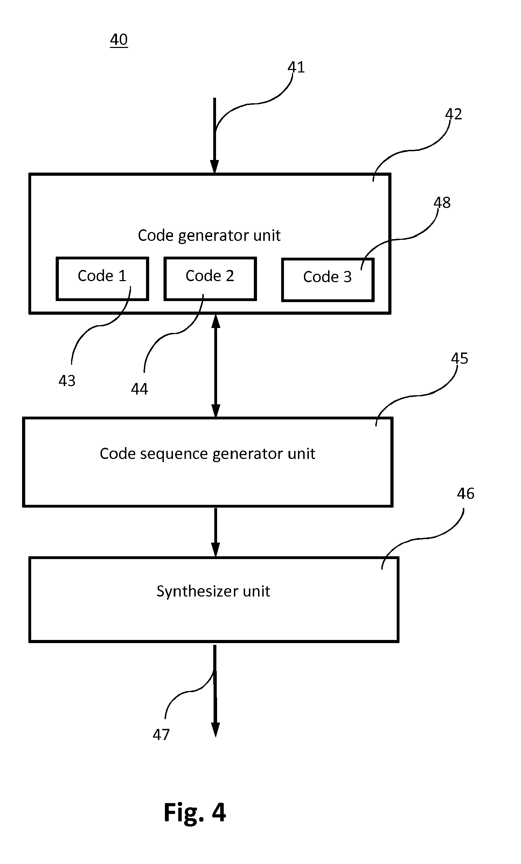

All three codes or code tables together contain 720 valid code words. The code tables will be applied alternately, e.g. by the device for generating code word sequences for nucleic acid storage channel modulation shown in Fig. 4, to avoid self-reverse complementary sections in oligos representing data to be stored. The three code tables Table B, Table C and Table D are abstractly described in eq. 10, 11 and 12, respectively:

$$byte\ b = (b_0, b_1, b_2, b_3, b_4, b_5, b_6, b_7) \xrightarrow{mapping} (n_{1,0}, n_{1,1}, n_{1,2}, n_{1,3}, n_{1,4}) = n_1, while$$

$$bit\ b_i \in \{0,1\}, 0 \le i \le 7$$

$$nucleotide\ n_{1,j} \in \{A, C, G, T\}, 0 \le j \le 4 \quad \text{(Table B)}$$

$$byte\ b = (b_0, b_1, b_2, b_3, b_4, b_5, b_6, b_7) \xrightarrow{mapping} (n_{2,0}, n_{2,1}, n_{2,2}, n_{2,3}, n_{2,4}) = n_2, while$$

$$bit\ b_i = \{0,1\}, 0 \le i \le 7$$

$$nucleotide\ n_{2,j} = \{A, C, G, T\}, 0 \le j \le 4 \quad \text{(Table C)}$$

$$byte\ b = (b_0, b_1, b_2, b_3, b_4, b_5, b_6, b_7) \xrightarrow{mapping} (n_{3,0}, n_{3,1}, n_{3,2}, n_{3,3}, n_{3,4}) = n_3, while$$

$$bit\ b_i = \{0,1\}, 0 \le i \le 7$$

$$nucleotide\ n_{2,j} = \{A, C, G, T\}, 0 \le j \le 4 \quad \text{(Table D)}$$

The code tables Table B, Table C and Table D are independent of each other, i.e. at least one nucleotide code symbol of the tuples, i.e. code words, differs:

**$n_1 \ne n_2 \ne n_3 \ \forall$ 256 *tuples,* $n_1 \in$ Table B, $n_2 \in$ Table C, $n_3 \in$ Table D.**

Still referring to Fig. 3, as an example, the second predefined length is set to equal 5 quaternary code symbols, and the channel modulation applied through the provision 32 of the quaternary code words comprises providing only different code words of the second predefined length where the second code symbol, the fourth code symbol and the fifth code symbol are set to assume any quaternary value and the first code symbol and the third code symbol are selected such that no code word is provided where the last three code symbols are identical and no code word is provided where the first two code symbols are identical. Here it is shown how the bits of a data byte can be mapped to the nucleotides of a $Nt_5$-Tuple:

$$b_0, b_1 \xrightarrow{mapping} n_{j,1}; \quad b_2, b_3 \xrightarrow{mapping} n_{j,3}; \quad b_4, b_5 \xrightarrow{mapping} n_{j,4}; \quad b_6, b_7 \xrightarrow{mapping} n_{j,0}, n_{j,2};$$

$j \in \{Table\ B,\ Table\ C, Table\ D\}$

Per definition $n_{j,1}$, $n_{j,3}$, $n_{j,4}$ store 2 bits each. The choice of $n_{j,2}$ and $n_{j,0}$ is not arbitrary; homopolymer series longer than 3 nucleotides may not arise.

As an example, the plurality of quaternary code words is provided 32 by generating code words where the fourth code symbol and the fifth code symbol are repeatedly set to assume all possible value combinations until twice the first amount of code words is generated, wherein the second code symbol is repeatedly set to assume all possible values, and the first code symbol and the third code symbol are selected from a table comprising 16 different value combinations of the first and the third code symbol, such as Table A.

Both $Nt_5$-tuple positions $nt_3$ and $nt_4$ may correspond to nucleotides of the same kind. Consequently, the last two $Nt_5$-tuple nucleotides can take on all possible nucleotide combinations in a repeatedly manner until all $nt_3$ and $nt_4$ nucleotides of all 256 code words of a code table are defined.

Since both $nt_0$ and $nt_1$ nucleotides of each $Nt_5$-tuple position must not be of the same kind, only the $nt_1$ nucleotides of all code tables and code words can be consecutively set with all kind of nucleotides.

The remaining $Nt_5$-tuple code symbols corresponding to nucleotides $nt_0$ and $nt_2$ can be chosen from a set of 16 nucleotide combinations in such a way that the design rules described above are not violated. The 16 nucleotide combinations are listed in Table A as shown above.

According to the example, Table E corresponding to a complete first code book, Table F corresponding to a complete second code book and Table G corresponding to an incomplete third code book are provided as annexes below.

Table E and Table F each consist of 10 columns: column "Index" represents a line index, columns "$nt_0$" to "$nt_4$" represent quaternary code symbols $nt_0$ to $nt_4$ corresponding to nucleotides of a code word or $Nt_5$-tuple, whereas columns "$(b_0, b_1)$" to "$(b_6, b_7)$" represent four bit pairs $b_0$ to $b_7$ to be encoded by the $Nt_5$-tuple of the same line.

Correspondingly, Table G also consists of 10 columns: column "Index" represents a line index, columns "$nt_0$" to "$nt_4$" represent quaternary code symbols $nt_0$ to $nt_4$ corresponding to nucleotides of a code word or $Nt_5$-tuple, whereas columns "$(b_0, b_1)$" to "$(b_6, b_7)$" represent four bit pairs $b_0$ to $b_7$ to be encoded by the $Nt_5$-tuple of the same line. Additionally, each line identified by an index number is followed by a line indicating whether or not the code word in the previous line is valid or not. Further, if the code word is indicated as invalid, a reason is given. Hence, while Table E and Table F directly correspond to the first and second code books, the third code book is given by the code words indicated as valid, whereas the code words indicated as invalid do not contribute to the third code book.

The valid code words of the three code tables Table E, Table F and Table G exhibit the same coding properties. In order to prevent occurrence of irregular sections when compiling or synthesizing the data representing oligos, code words of all three code tables are used to encode the data to be stored.

In order to illustrate the mapping by an example, a small segment of code Table E is shown below in Table H, while the complete code Tables E, F and G are annexed below.

| Data byte | | | | | | | | | Nt₅-Tuple | | | | |
|---|---|---|---|---|---|---|---|---|---|---|---|---|---|
| $b_0$ | $b_1$ | $b_2$ | $b_3$ | $b_4$ | $b_5$ | $b_6$ | $b_7$ | | $n_{1,0}$ | $n_{1,1}$ | $n_{1,2}$ | $n_{1,3}$ | $n_{1,4}$ |
| 0 | 0 | 0 | 0 | 0 | 0 | 0 | 0 | | C | A | C | A | A |
| 0 | 0 | 0 | 0 | 0 | 0 | 0 | 1 | | G | A | C | A | A |
| 0 | 0 | 0 | 0 | 0 | 0 | 1 | 0 | | T | A | C | A | A |
| 0 | 0 | 0 | 0 | 0 | 0 | 1 | 1 | | C | A | G | A | C |

(Table H)

$b_0$ and $b_1$ are represented by code symbol $n_{1,1}$, $b_2$ and $b_3$ are represented by $n_{1,3}$, $b_4$ and $b_5$ are represented by $n_{1,4}$, and $b_6$ and $b_7$ are represented by code symbols $n_{1,0}$ and $n_{1,2}$.

The homopolymer run-length constraint is met because the code words have been defined accordingly. In the described example the homopolymer run-length does not exceed 3 code symbols or nucleotides, respectively.

Referring to Fig. 4, a device 40 for generating code word sequences for nucleic acid storage channel modulation according to another embodiment of the invention is schematically illustrated. The shown device allows implementing the advantages and characteristics of the described method for generating codes for nucleic acid storage as part of a device for generating code word sequences for nucleic acid storage channel modulation.

The device 40 for generating code word sequences for nucleic acid storage channel modulation comprises an interface or other input 41 for receiving user data. The user data are received, e.g., from a memory device or a processing device arranged to generate the user data. In an embodiment the memory device or processing device can be comprised in the device 40.

The device 40 further comprises a code generator unit 42 configured to generate at least a first code book 43 and a second code book 44. The first code book 43 and the second code book 44 comprise a complete mapping of a plurality of information units of a first predefined length to corresponding quaternary code words of a second predefined length of the first code book 43 and of the second code book 44. None of the code words belongs to the first 43 and also to the second code book 44. None of the code books 43, 44 comprises a code word where the last three code symbols are identical, and none of the code books 43, 44 comprises a code word where the first two code symbols are identical.

In an embodiment, the code generator unit 42 corresponds, e.g., to a processing device, or a module of a processing device, connected to memory, configured to generate the code books or parts of it as required. In another embodiment, the code generator unit 42 corresponds to one or more tables of modulation codes partitioned into at least a first code book and a second code book, wherein the tables are provided, e.g., stored in a memory device or read from a storage medium.

The device 40 further comprises a code word sequence generator unit 45 configured to receive user data encoded using the plurality of information units, to map the information units encoding the user data to corresponding code words selected from at least one of the first code book and the second code book, and to generate at least one code word sequence by concatenating said selected corresponding code words.

In the embodiment shown in Fig.4, the illustrated device 40 comprises a synthesizer unit 46 connected to receive the generated code word sequences. The code word sequences are provided to the synthesizer unit 46 configured to synthesize at least one nucleic acid molecule comprising a segment wherein a sequence of nucleotides is arranged to correspond to the at least one code word sequence. In the embodiment shown in Fig.4, the illustrated device 40 comprises the synthesizer unit 46. In another embodiment, the device does not comprise the synthesizer unit but is connected or connectable to it by means of an interface.

The synthesizer unit 46 comprises an output 47 for outputting synthesized nucleic acid molecules to, for example, a nucleic acid storage container.

According to the shown embodiment, the code word generator unit 42 is configured to generate at least a third code book 48 in addition to the first code book 43 and the second code book 44. Similarly to the first code book 43 and the second code book 44, the third code book 48 comprises a mapping of at least a subset of the plurality of information units to corresponding code words of the third code book 48, wherein none of the code words of the third code book 48 belongs to the first and the second code book, the third code book 48 does not comprise a code word where the last three code symbols are identical, and the third code book 48 does not comprise a code word where the first two code symbols are identical. The third code book 48 is not required to provide a complete mapping of all information units to corresponding code words.

The provided device 40 allows generating code word sequences and oligos that meet the self-reverse complementary constraint.

The shown code word sequence generator unit 45 is configured to map the information units encoding the user data to corresponding code words alternately selected from the first code book 43 and the second code book 44.

Further, the shown code word sequence generator unit 44 is configured to remove the most recently appended code word from the code word sequence being generated and append the corresponding code word of the other of the first code book 43 and the second code book 44, if that code word sequence violates the self-reverse complementarity constraint by comprising a self-reverse complementary section having a length of at least twice the second predefined length. For example, for code words of length 5, self-reverse complementary sections of 10 or more code symbols, respectively nucleotides, are avoided.

The third code book 48 is used by the code word sequence generator unit 45 as follows: The code word sequence generator unit 45 removes the most recently appended code word from the code word sequence and appends the corresponding code word of the third code book 48, if the code word sequence comprises a self-reverse complementary section having a length of at least twice the second predefined length. This is carried out if after replacing the most recently appended code word by the corresponding code word of the first code book 43 or of the second code book 44 the code word sequence still comprises such a section and given that the third code book 48 actually comprises a corresponding code word.

The shown device 40, therefore, allows to generate code word sequences and oligos that meet the self-reverse complementary constraint by providing means adapted to carry out an algorithm to form the data representing oligos. The algorithm works iteratively while stepping exhaustively through all possibilities to form a regular oligo. In its extremes it exhaustively checks all $Nt_5$ concatenation possibilities.

As described, the device 40 is configured to apply the three code tables or, respectively, code books 43, 44, 48 such as to enable meeting to a very high degree the self-reverse complementary constraint according to the following algorithm: At first, the complete two code tables are byte wise alternately applied as long as only self-reverse complementary sections shorter than $2\times5=10$ nucleotides in an oligo are being formed. Then, if an irregular section in an oligo is formed according to the run length constraint, the alternation of the code tables is suspended for this byte. Then, if still an irregular section in an oligo would be formed according to the self-reverse complementary constraint, the algorithm starts again for the preceding byte, while now the other complete code table is applied. If no solution can be found using the complete code tables 43, 44, additionally the third incomplete code table 48 is used if a valid code word is available in it.

Hence, a method 30 and a device 40 are provided which allow channel modulated data storage in synthesized nucleic acid molecules that limits homopolymer run-lengths of modulation sequences, avoids self-reverse complementarity, and minimizes an impact of symbol errors in the sequenced nucleic acid molecules on errors within the user data after demodulation.

The device 40 may, for example, at least partly be programmable logic circuitry or a processing device, connected to or comprising at least one memory device. The code word generator unit 41 and the code word sequence generator unit 45 may, for example, be provided as separate devices, jointly as at least one device or logic circuitry, or functionality carried out by a microprocessor, microcontroller or other processing device, computer or other programmable apparatus.

In an embodiment, the device 40 is a device being part of another device or apparatus or system, such as a storage system, e.g. a DNA storage system or RNA storage system.

As will be appreciated by one skilled in the art, aspects of the present principles can be embodied as a device, an apparatus, a system, method or computer readable medium. Accordingly, aspects of the present principles can take the form of a hardware embodiment, a software embodiment or an embodiment combining software and hardware aspects. Furthermore, aspects of the present principles can take the form of a computer readable storage medium. Any combination of one or more computer readable storage medium(s) may be utilized.

Aspects of the invention may, for example, at least partly be implemented in a computer program comprising code portions for performing steps of the method according to an embodiment of the invention when run on a programmable apparatus or enabling a programmable apparatus to perform functions of an apparatus or system according to an embodiment of the invention.

Further, any shown connection may be a direct or an indirect connection. Furthermore, those skilled in the art will recognize that the boundaries between logic blocks are merely illustrative and that alternative embodiments may merge logic blocks or impose an alternate decomposition of functionality upon various logic blocks.

**TABLE E**

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[ 1] : | C | A | C | A | A | 00 | 00 | 00 | 00 |
| A[ 2] : | G | A | C | A | A | 00 | 00 | 00 | 01 |
| A[ 3] : | T | A | C | A | A | 00 | 00 | 00 | 10 |
| A[ 4] : | C | A | G | A | A | 00 | 00 | 00 | 11 |
| A[ 5] : | G | C | G | A | A | 00 | 00 | 01 | 00 |
| A[ 6] : | G | C | C | A | A | 00 | 00 | 01 | 01 |
| A[ 7] : | T | C | C | A | A | 00 | 00 | 01 | 10 |
| A[ 8] : | A | C | C | A | A | 00 | 00 | 01 | 11 |
| A[ 9] : | C | G | C | A | A | 00 | 00 | 10 | 00 |
| A[ 10] : | T | G | G | A | A | 00 | 00 | 10 | 01 |
| A[ 11] : | T | G | C | A | A | 00 | 00 | 10 | 10 |
| A[ 12] : | A | G | C | A | A | 00 | 00 | 10 | 11 |
| A[ 13] : | C | T | C | A | A | 00 | 00 | 11 | 00 |
| A[ 14] : | G | T | C | A | A | 00 | 00 | 11 | 01 |
| A[ 15] : | A | T | G | A | A | 00 | 00 | 11 | 10 |
| A[ 16] : | A | T | C | A | A | 00 | 00 | 11 | 11 |
| A[ 17] : | G | A | G | C | A | 00 | 01 | 00 | 00 |
| A[ 18] : | C | A | A | C | A | 00 | 01 | 00 | 01 |
| A[ 19] : | G | A | A | C | A | 00 | 01 | 00 | 10 |
| A[ 20] : | C | A | G | C | A | 00 | 01 | 00 | 11 |
| A[ 21] : | G | C | G | C | A | 00 | 01 | 01 | 00 |
| A[ 22] : | T | C | G | C | A | 00 | 01 | 01 | 01 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[ 23] : | G | C | A | C | A | 00 | 01 | 01 | 10 |
| A[ 24] : | T | C | A | C | A | 00 | 01 | 01 | 11 |
| A[ 25] : | A | G | A | C | A | 00 | 01 | 10 | 00 |
| A[ 26] : | C | G | A | C | A | 00 | 01 | 10 | 01 |
| A[ 27] : | A | G | G | C | A | 00 | 01 | 10 | 10 |
| A[ 28] : | T | G | A | C | A | 00 | 01 | 10 | 11 |
| A[ 29] : | A | T | A | C | A | 00 | 01 | 11 | 00 |
| A[ 30] : | C | T | A | C | A | 00 | 01 | 11 | 01 |
| A[ 31] : | G | T | A | C | A | 00 | 01 | 11 | 10 |
| A[ 32] : | C | T | G | C | A | 00 | 01 | 11 | 11 |
| A[ 33] : | C | A | C | G | A | 00 | 10 | 00 | 00 |
| A[ 34] : | C | A | A | G | A | 00 | 10 | 00 | 01 |
| A[ 35] : | T | A | C | G | A | 00 | 10 | 00 | 10 |
| A[ 36] : | T | A | A | G | A | 00 | 10 | 00 | 11 |
| A[ 37] : | A | C | A | G | A | 00 | 10 | 01 | 00 |
| A[ 38] : | G | C | C | G | A | 00 | 10 | 01 | 01 |
| A[ 39] : | G | C | A | G | A | 00 | 10 | 01 | 10 |
| A[ 40] : | T | C | A | G | A | 00 | 10 | 01 | 11 |
| A[ 41] : | C | G | C | G | A | 00 | 10 | 10 | 00 |
| A[ 42] : | C | G | A | G | A | 00 | 10 | 10 | 01 |
| A[ 43] : | T | G | C | G | A | 00 | 10 | 10 | 10 |
| A[ 44] : | T | G | A | G | A | 00 | 10 | 10 | 11 |
| A[ 45] : | A | T | A | G | A | 00 | 10 | 11 | 00 |
| A[ 46] : | C | T | A | G | A | 00 | 10 | 11 | 01 |
| A[ 47] : | G | T | A | G | A | 00 | 10 | 11 | 10 |
| A[ 48] : | A | T | C | G | A | 00 | 10 | 11 | 11 |
| A[ 49] : | C | A | C | T | A | 00 | 11 | 00 | 00 |
| A[ 50] : | G | A | C | T | A | 00 | 11 | 00 | 01 |
| A[ 51] : | G | A | A | T | A | 00 | 11 | 00 | 10 |
| A[ 52] : | T | A | A | T | A | 00 | 11 | 00 | 11 |
| A[ 53] : | A | C | A | T | A | 00 | 11 | 01 | 00 |
| A[ 54] : | G | C | C | T | A | 00 | 11 | 01 | 01 |
| A[ 55] : | G | C | A | T | A | 00 | 11 | 01 | 10 |
| A[ 56] : | T | C | A | T | A | 00 | 11 | 01 | 11 |
| A[ 57] : | A | G | A | T | A | 00 | 11 | 10 | 00 |
| A[ 58] : | C | G | A | T | A | 00 | 11 | 10 | 01 |
| A[ 59] : | T | G | C | T | A | 00 | 11 | 10 | 10 |
| A[ 60] : | T | G | A | T | A | 00 | 11 | 10 | 11 |
| A[ 61] : | C | T | C | T | A | 00 | 11 | 11 | 00 |
| A[ 62] : | C | T | A | T | A | 00 | 11 | 11 | 01 |
| A[ 63] : | G | T | A | T | A | 00 | 11 | 11 | 10 |
| A[ 64] : | A | T | C | T | A | 00 | 11 | 11 | 11 |
| A[ 65] : | C | A | C | A | C | 01 | 00 | 00 | 00 |
| A[ 66] : | G | A | C | A | C | 01 | 00 | 00 | 01 |
| A[ 67] : | T | A | C | A | C | 01 | 00 | 00 | 10 |
| A[ 68] : | C | A | G | A | C | 01 | 00 | 00 | 11 |
| A[ 69] : | G | C | G | A | C | 01 | 00 | 01 | 00 |
| A[ 70] : | G | C | C | A | C | 01 | 00 | 01 | 01 |
| A[ 71] : | T | C | C | A | C | 01 | 00 | 01 | 10 |
| A[ 72] : | A | C | C | A | C | 01 | 00 | 01 | 11 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[ 73] : | C | G | C | A | C | 01 | 00 | 10 | 00 |
| A[ 74] : | T | G | G | A | C | 01 | 00 | 10 | 01 |
| A[ 75] : | T | G | C | A | C | 01 | 00 | 10 | 10 |
| A[ 76] : | A | G | C | A | C | 01 | 00 | 10 | 11 |
| A[ 77] : | C | T | C | A | C | 01 | 00 | 11 | 00 |
| A[ 78] : | G | T | C | A | C | 01 | 00 | 11 | 01 |
| A[ 79] : | A | T | G | A | C | 01 | 00 | 11 | 10 |
| A[ 80] : | A | T | C | A | C | 01 | 00 | 11 | 11 |
| A[ 81] : | G | A | G | C | C | 01 | 01 | 00 | 00 |
| A[ 82] : | C | A | A | C | C | 01 | 01 | 00 | 01 |
| A[ 83] : | G | A | A | C | C | 01 | 01 | 00 | 10 |
| A[ 84] : | C | A | G | C | C | 01 | 01 | 00 | 11 |
| A[ 85] : | G | C | G | C | C | 01 | 01 | 01 | 00 |
| A[ 86] : | T | C | G | C | C | 01 | 01 | 01 | 01 |
| A[ 87] : | G | C | A | C | C | 01 | 01 | 01 | 10 |
| A[ 88] : | T | C | A | C | C | 01 | 01 | 01 | 11 |
| A[ 89] : | A | G | A | C | C | 01 | 01 | 10 | 00 |
| A[ 90] : | C | G | A | C | C | 01 | 01 | 10 | 01 |
| A[ 91] : | A | G | G | C | C | 01 | 01 | 10 | 10 |
| A[ 92] : | T | G | A | C | C | 01 | 01 | 10 | 11 |
| A[ 93] : | A | T | A | C | C | 01 | 01 | 11 | 00 |
| A[ 94] : | C | T | A | C | C | 01 | 01 | 11 | 01 |
| A[ 95] : | G | T | A | C | C | 01 | 01 | 11 | 10 |
| A[ 96] : | C | T | G | C | C | 01 | 01 | 11 | 11 |
| A[ 97] : | C | A | C | G | C | 01 | 10 | 00 | 00 |
| A[ 98] : | C | A | A | G | C | 01 | 10 | 00 | 01 |
| A[ 99] : | T | A | C | G | C | 01 | 10 | 00 | 10 |
| A[100] : | T | A | A | G | C | 01 | 10 | 00 | 11 |
| A[101] : | A | C | A | G | C | 01 | 10 | 01 | 00 |
| A[102] : | G | C | C | G | C | 01 | 10 | 01 | 01 |
| A[103] : | G | C | A | G | C | 01 | 10 | 01 | 10 |
| A[104] : | T | C | A | G | C | 01 | 10 | 01 | 11 |
| A[105] : | C | G | C | G | C | 01 | 10 | 10 | 00 |
| A[106] : | C | G | A | G | C | 01 | 10 | 10 | 01 |
| A[107] : | T | G | C | G | C | 01 | 10 | 10 | 10 |
| A[108] : | T | G | A | G | C | 01 | 10 | 10 | 11 |
| A[109] : | A | T | A | G | C | 01 | 10 | 11 | 00 |
| A[110] : | C | T | A | G | C | 01 | 10 | 11 | 01 |
| A[111] : | G | T | A | G | C | 01 | 10 | 11 | 10 |
| A[112] : | A | T | C | G | C | 01 | 10 | 11 | 11 |
| A[113] : | C | A | C | T | C | 01 | 11 | 00 | 00 |
| A[114] : | G | A | C | T | C | 01 | 11 | 00 | 01 |
| A[115] : | G | A | A | T | C | 01 | 11 | 00 | 10 |
| A[116] : | T | A | A | T | C | 01 | 11 | 00 | 11 |
| A[117] : | A | C | A | T | C | 01 | 11 | 01 | 00 |
| A[118] : | G | C | C | T | C | 01 | 11 | 01 | 01 |
| A[119] : | G | C | A | T | C | 01 | 11 | 01 | 10 |
| A[120] : | T | C | A | T | C | 01 | 11 | 01 | 11 |
| A[121] : | A | G | A | T | C | 01 | 11 | 10 | 00 |
| A[122] : | C | G | A | T | C | 01 | 11 | 10 | 01 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|-------|--------|--------|--------|--------|--------|--------------|--------------|--------------|--------------|
| A[123] : | T | G | C | T | C | 01 | 11 | 10 | 10 |
| A[124] : | T | G | A | T | C | 01 | 11 | 10 | 11 |
| A[125] : | C | T | C | T | C | 01 | 11 | 11 | 00 |
| A[126] : | C | T | A | T | C | 01 | 11 | 11 | 01 |
| A[127] : | G | T | A | T | C | 01 | 11 | 11 | 10 |
| A[128] : | A | T | C | T | C | 01 | 11 | 11 | 11 |
| A[129] : | C | A | C | A | G | 10 | 00 | 00 | 00 |
| A[130] : | G | A | C | A | G | 10 | 00 | 00 | 01 |
| A[131] : | T | A | C | A | G | 10 | 00 | 00 | 10 |
| A[132] : | C | A | G | A | G | 10 | 00 | 00 | 11 |
| A[133] : | G | C | G | A | G | 10 | 00 | 01 | 00 |
| A[134] : | G | C | C | A | G | 10 | 00 | 01 | 01 |
| A[135] : | T | C | C | A | G | 10 | 00 | 01 | 10 |
| A[136] : | A | C | C | A | G | 10 | 00 | 01 | 11 |
| A[137] : | C | G | C | A | G | 10 | 00 | 10 | 00 |
| A[138] : | T | G | G | A | G | 10 | 00 | 10 | 01 |
| A[139] : | T | G | C | A | G | 10 | 00 | 10 | 10 |
| A[140] : | A | G | C | A | G | 10 | 00 | 10 | 11 |
| A[141] : | C | T | C | A | G | 10 | 00 | 11 | 00 |
| A[142] : | G | T | C | A | G | 10 | 00 | 11 | 01 |
| A[143] : | A | T | G | A | G | 10 | 00 | 11 | 10 |
| A[144] : | A | T | C | A | G | 10 | 00 | 11 | 11 |
| A[145] : | G | A | G | C | G | 10 | 01 | 00 | 00 |
| A[146] : | C | A | A | C | G | 10 | 01 | 00 | 01 |
| A[147] : | G | A | A | C | G | 10 | 01 | 00 | 10 |
| A[148] : | C | A | G | C | G | 10 | 01 | 00 | 11 |
| A[149] : | G | C | G | C | G | 10 | 01 | 01 | 00 |
| A[150] : | T | C | G | C | G | 10 | 01 | 01 | 01 |
| A[151] : | G | C | A | C | G | 10 | 01 | 01 | 10 |
| A[152] : | T | C | A | C | G | 10 | 01 | 01 | 11 |
| A[153] : | A | G | A | C | G | 10 | 01 | 10 | 00 |
| A[154] : | C | G | A | C | G | 10 | 01 | 10 | 01 |
| A[155] : | A | G | G | C | G | 10 | 01 | 10 | 10 |
| A[156] : | T | G | A | C | G | 10 | 01 | 10 | 11 |
| A[157] : | A | T | A | C | G | 10 | 01 | 11 | 00 |
| A[158] : | C | T | A | C | G | 10 | 01 | 11 | 01 |
| A[159] : | G | T | A | C | G | 10 | 01 | 11 | 10 |
| A[160] : | C | T | G | C | G | 10 | 01 | 11 | 11 |
| A[161] : | C | A | C | G | G | 10 | 10 | 00 | 00 |
| A[162] : | C | A | A | G | G | 10 | 10 | 00 | 01 |
| A[163] : | T | A | C | G | G | 10 | 10 | 00 | 10 |
| A[164] : | T | A | A | G | G | 10 | 10 | 00 | 11 |
| A[165] : | A | C | A | G | G | 10 | 10 | 01 | 00 |
| A[166] : | G | C | C | G | G | 10 | 10 | 01 | 01 |
| A[167] : | G | C | A | G | G | 10 | 10 | 01 | 10 |
| A[168] : | T | C | A | G | G | 10 | 10 | 01 | 11 |
| A[169] : | C | G | C | G | G | 10 | 10 | 10 | 00 |
| A[170] : | C | G | A | G | G | 10 | 10 | 10 | 01 |
| A[171] : | T | G | C | G | G | 10 | 10 | 10 | 10 |
| A[172] : | T | G | A | G | G | 10 | 10 | 10 | 11 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[173] : | A | T | A | G | G | 10 | 10 | 11 | 00 |
| A[174] : | C | T | A | G | G | 10 | 10 | 11 | 01 |
| A[175] : | G | T | A | G | G | 10 | 10 | 11 | 10 |
| A[176] : | A | T | C | G | G | 10 | 10 | 11 | 11 |
| A[177] : | C | A | C | T | G | 10 | 11 | 00 | 00 |
| A[178] : | G | A | C | T | G | 10 | 11 | 00 | 01 |
| A[179] : | G | A | A | T | G | 10 | 11 | 00 | 10 |
| A[180] : | T | A | A | T | G | 10 | 11 | 00 | 11 |
| A[181] : | A | C | A | T | G | 10 | 11 | 01 | 00 |
| A[182] : | G | C | C | T | G | 10 | 11 | 01 | 01 |
| A[183] : | G | C | A | T | G | 10 | 11 | 01 | 10 |
| A[184] : | T | C | A | T | G | 10 | 11 | 01 | 11 |
| A[185] : | A | G | A | T | G | 10 | 11 | 10 | 00 |
| A[186] : | C | G | A | T | G | 10 | 11 | 10 | 01 |
| A[187] : | T | G | C | T | G | 10 | 11 | 10 | 10 |
| A[188] : | T | G | A | T | G | 10 | 11 | 10 | 11 |
| A[189] : | C | T | C | T | G | 10 | 11 | 11 | 00 |
| A[190] : | C | T | A | T | G | 10 | 11 | 11 | 01 |
| A[191] : | G | T | A | T | G | 10 | 11 | 11 | 10 |
| A[192] : | A | T | C | T | G | 10 | 11 | 11 | 11 |
| A[193] : | C | A | C | A | T | 11 | 00 | 00 | 00 |
| A[194] : | G | A | C | A | T | 11 | 00 | 00 | 01 |
| A[195] : | T | A | C | A | T | 11 | 00 | 00 | 10 |
| A[196] : | C | A | G | A | T | 11 | 00 | 00 | 11 |
| A[197] : | G | C | G | A | T | 11 | 00 | 01 | 00 |
| A[198] : | G | C | C | A | T | 11 | 00 | 01 | 01 |
| A[199] : | T | C | C | A | T | 11 | 00 | 01 | 10 |
| A[200] : | A | C | C | A | T | 11 | 00 | 01 | 11 |
| A[201] : | C | G | C | A | T | 11 | 00 | 10 | 00 |
| A[202] : | T | G | G | A | T | 11 | 00 | 10 | 01 |
| A[203] : | T | G | C | A | T | 11 | 00 | 10 | 10 |
| A[204] : | A | G | C | A | T | 11 | 00 | 10 | 11 |
| A[205] : | C | T | C | A | T | 11 | 00 | 11 | 00 |
| A[206] : | G | T | C | A | T | 11 | 00 | 11 | 01 |
| A[207] : | A | T | G | A | T | 11 | 00 | 11 | 10 |
| A[208] : | A | T | C | A | T | 11 | 00 | 11 | 11 |
| A[209] : | G | A | G | C | T | 11 | 01 | 00 | 00 |
| A[210] : | C | A | A | C | T | 11 | 01 | 00 | 01 |
| A[211] : | G | A | A | C | T | 11 | 01 | 00 | 10 |
| A[212] : | C | A | G | C | T | 11 | 01 | 00 | 11 |
| A[213] : | G | C | G | C | T | 11 | 01 | 01 | 00 |
| A[214] : | T | C | G | C | T | 11 | 01 | 01 | 01 |
| A[215] : | G | C | A | C | T | 11 | 01 | 01 | 10 |
| A[216] : | T | C | A | C | T | 11 | 01 | 01 | 11 |
| A[217] : | A | G | A | C | T | 11 | 01 | 10 | 00 |
| A[218] : | C | G | A | C | T | 11 | 01 | 10 | 01 |
| A[219] : | A | G | G | C | T | 11 | 01 | 10 | 10 |
| A[220] : | T | G | A | C | T | 11 | 01 | 10 | 11 |
| A[221] : | A | T | A | C | T | 11 | 01 | 11 | 00 |
| A[222] : | C | T | A | C | T | 11 | 01 | 11 | 01 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| A[223] : | G | T | A | C | T | 11 | 01 | 11 | 10 |
| A[224] : | C | T | G | C | T | 11 | 01 | 11 | 11 |
| A[225] : | C | A | C | G | T | 11 | 10 | 00 | 00 |
| A[226] : | C | A | A | G | T | 11 | 10 | 00 | 01 |
| A[227] : | T | A | C | G | T | 11 | 10 | 00 | 10 |
| A[228] : | T | A | A | G | T | 11 | 10 | 00 | 11 |
| A[229] : | A | C | A | G | T | 11 | 10 | 01 | 00 |
| A[230] : | G | C | C | G | T | 11 | 10 | 01 | 01 |
| A[231] : | G | C | A | G | T | 11 | 10 | 01 | 10 |
| A[232] : | T | C | A | G | T | 11 | 10 | 01 | 11 |
| A[233] : | C | G | C | G | T | 11 | 10 | 10 | 00 |
| A[234] : | C | G | A | G | T | 11 | 10 | 10 | 01 |
| A[235] : | T | G | C | G | T | 11 | 10 | 10 | 10 |
| A[236] : | T | G | A | G | T | 11 | 10 | 10 | 11 |
| A[237] : | A | T | A | G | T | 11 | 10 | 11 | 00 |
| A[238] : | C | T | A | G | T | 11 | 10 | 11 | 01 |
| A[239] : | G | T | A | G | T | 11 | 10 | 11 | 10 |
| A[240] : | A | T | C | G | T | 11 | 10 | 11 | 11 |
| A[241] : | C | A | C | T | T | 11 | 11 | 00 | 00 |
| A[242] : | G | A | C | T | T | 11 | 11 | 00 | 01 |
| A[243] : | G | A | A | T | T | 11 | 11 | 00 | 10 |
| A[244] : | T | A | A | T | T | 11 | 11 | 00 | 11 |
| A[245] : | A | C | A | T | T | 11 | 11 | 01 | 00 |
| A[246] : | G | C | C | T | T | 11 | 11 | 01 | 01 |
| A[247] : | G | C | A | T | T | 11 | 11 | 01 | 10 |
| A[248] : | T | C | A | T | T | 11 | 11 | 01 | 11 |
| A[249] : | A | G | A | T | T | 11 | 11 | 10 | 00 |
| A[250] : | C | G | A | T | T | 11 | 11 | 10 | 01 |
| A[251] : | T | G | C | T | T | 11 | 11 | 10 | 10 |
| A[252] : | T | G | A | T | T | 11 | 11 | 10 | 11 |
| A[253] : | C | T | C | T | T | 11 | 11 | 11 | 00 |
| A[254] : | C | T | A | T | T | 11 | 11 | 11 | 01 |
| A[255] : | G | T | A | T | T | 11 | 11 | 11 | 10 |
| A[256] : | A | T | C | T | T | 11 | 11 | 11 | 11 |

**TABLE F**

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| A[ 1] : | G | A | G | A | A | 00 | 00 | 00 | 00 |
| A[ 2] : | T | A | G | A | A | 00 | 00 | 00 | 01 |
| A[ 3] : | C | A | T | A | A | 00 | 00 | 00 | 10 |
| A[ 4] : | G | A | T | A | A | 00 | 00 | 00 | 11 |
| A[ 5] : | T | C | T | A | A | 00 | 00 | 01 | 00 |
| A[ 6] : | T | C | G | A | A | 00 | 00 | 01 | 01 |
| A[ 7] : | A | C | G | A | A | 00 | 00 | 01 | 10 |
| A[ 8] : | G | C | T | A | A | 00 | 00 | 01 | 11 |
| A[ 9] : | T | G | T | A | A | 00 | 00 | 10 | 00 |
| A[ 10] : | A | G | T | A | A | 00 | 00 | 10 | 01 |
| A[ 11] : | C | G | T | A | A | 00 | 00 | 10 | 10 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[ 12 ] : | C | G | G | A | A | 00 | 00 | 10 | 11 |
| A[ 13 ] : | G | T | G | A | A | 00 | 00 | 11 | 00 |
| A[ 14 ] : | A | T | T | A | A | 00 | 00 | 11 | 01 |
| A[ 15 ] : | C | T | T | A | A | 00 | 00 | 11 | 10 |
| A[ 16 ] : | C | T | G | A | A | 00 | 00 | 11 | 11 |
| A[ 17 ] : | T | A | T | C | A | 00 | 01 | 00 | 00 |
| A[ 18 ] : | T | A | G | C | A | 00 | 01 | 00 | 01 |
| A[ 19 ] : | C | A | T | C | A | 00 | 01 | 00 | 10 |
| A[ 20 ] : | G | A | T | C | A | 00 | 01 | 00 | 11 |
| A[ 21 ] : | T | C | T | C | A | 00 | 01 | 01 | 00 |
| A[ 22 ] : | A | C | T | C | A | 00 | 01 | 01 | 01 |
| A[ 23 ] : | A | C | G | C | A | 00 | 01 | 01 | 10 |
| A[ 24 ] : | G | C | T | C | A | 00 | 01 | 01 | 11 |
| A[ 25 ] : | T | G | T | C | A | 00 | 01 | 10 | 00 |
| A[ 26 ] : | A | G | T | C | A | 00 | 01 | 10 | 01 |
| A[ 27 ] : | C | G | T | C | A | 00 | 01 | 10 | 10 |
| A[ 28 ] : | C | G | G | C | A | 00 | 01 | 10 | 11 |
| A[ 29 ] : | G | T | G | C | A | 00 | 01 | 11 | 00 |
| A[ 30 ] : | A | T | T | C | A | 00 | 01 | 11 | 01 |
| A[ 31 ] : | A | T | G | C | A | 00 | 01 | 11 | 10 |
| A[ 32 ] : | G | T | T | C | A | 00 | 01 | 11 | 11 |
| A[ 33 ] : | T | A | T | G | A | 00 | 10 | 00 | 00 |
| A[ 34 ] : | G | A | C | G | A | 00 | 10 | 00 | 01 |
| A[ 35 ] : | C | A | T | G | A | 00 | 10 | 00 | 10 |
| A[ 36 ] : | G | A | T | G | A | 00 | 10 | 00 | 11 |
| A[ 37 ] : | T | C | T | G | A | 00 | 10 | 01 | 00 |
| A[ 38 ] : | A | C | T | G | A | 00 | 10 | 01 | 01 |
| A[ 39 ] : | T | C | C | G | A | 00 | 10 | 01 | 10 |
| A[ 40 ] : | G | C | T | G | A | 00 | 10 | 01 | 11 |
| A[ 41 ] : | T | G | T | G | A | 00 | 10 | 10 | 00 |
| A[ 42 ] : | A | G | T | G | A | 00 | 10 | 10 | 01 |
| A[ 43 ] : | C | G | T | G | A | 00 | 10 | 10 | 10 |
| A[ 44 ] : | A | G | C | G | A | 00 | 10 | 10 | 11 |
| A[ 45 ] : | C | T | C | G | A | 00 | 10 | 11 | 00 |
| A[ 46 ] : | G | T | C | G | A | 00 | 10 | 11 | 01 |
| A[ 47 ] : | C | T | T | G | A | 00 | 10 | 11 | 10 |
| A[ 48 ] : | G | T | T | G | A | 00 | 10 | 11 | 11 |
| A[ 49 ] : | G | A | G | T | A | 00 | 11 | 00 | 00 |
| A[ 50 ] : | T | A | G | T | A | 00 | 11 | 00 | 01 |
| A[ 51 ] : | T | A | C | T | A | 00 | 11 | 00 | 10 |
| A[ 52 ] : | C | A | G | T | A | 00 | 11 | 00 | 11 |
| A[ 53 ] : | G | C | G | T | A | 00 | 11 | 01 | 00 |
| A[ 54 ] : | T | C | G | T | A | 00 | 11 | 01 | 01 |
| A[ 55 ] : | A | C | G | T | A | 00 | 11 | 01 | 10 |
| A[ 56 ] : | A | C | C | T | A | 00 | 11 | 01 | 11 |
| A[ 57 ] : | C | G | C | T | A | 00 | 11 | 10 | 00 |
| A[ 58 ] : | T | G | G | T | A | 00 | 11 | 10 | 01 |
| A[ 59 ] : | A | G | G | T | A | 00 | 11 | 10 | 10 |
| A[ 60 ] : | A | G | C | T | A | 00 | 11 | 10 | 11 |
| A[ 61 ] : | G | T | G | T | A | 00 | 11 | 11 | 00 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[ 62] : | G | T | C | T | A | 00 | 11 | 11 | 01 |
| A[ 63] : | A | T | G | T | A | 00 | 11 | 11 | 10 |
| A[ 64] : | C | T | G | T | A | 00 | 11 | 11 | 11 |
| A[ 65] : | G | A | G | A | C | 01 | 00 | 00 | 00 |
| A[ 66] : | T | A | G | A | C | 01 | 00 | 00 | 01 |
| A[ 67] : | C | A | T | A | C | 01 | 00 | 00 | 10 |
| A[ 68] : | G | A | T | A | C | 01 | 00 | 00 | 11 |
| A[ 69] : | T | C | T | A | C | 01 | 00 | 01 | 00 |
| A[ 70] : | T | C | G | A | C | 01 | 00 | 01 | 01 |
| A[ 71] : | A | C | G | A | C | 01 | 00 | 01 | 10 |
| A[ 72] : | G | C | T | A | C | 01 | 00 | 01 | 11 |
| A[ 73] : | T | G | T | A | C | 01 | 00 | 10 | 00 |
| A[ 74] : | A | G | T | A | C | 01 | 00 | 10 | 01 |
| A[ 75] : | C | G | T | A | C | 01 | 00 | 10 | 10 |
| A[ 76] : | C | G | G | A | C | 01 | 00 | 10 | 11 |
| A[ 77] : | G | T | G | A | C | 01 | 00 | 11 | 00 |
| A[ 78] : | A | T | T | A | C | 01 | 00 | 11 | 01 |
| A[ 79] : | C | T | T | A | C | 01 | 00 | 11 | 10 |
| A[ 80] : | C | T | G | A | C | 01 | 00 | 11 | 11 |
| A[ 81] : | T | A | T | C | C | 01 | 01 | 00 | 00 |
| A[ 82] : | T | A | G | C | C | 01 | 01 | 00 | 01 |
| A[ 83] : | C | A | T | C | C | 01 | 01 | 00 | 10 |
| A[ 84] : | G | A | T | C | C | 01 | 01 | 00 | 11 |
| A[ 85] : | T | C | T | C | C | 01 | 01 | 01 | 00 |
| A[ 86] : | A | C | T | C | C | 01 | 01 | 01 | 01 |
| A[ 87] : | A | C | G | C | C | 01 | 01 | 01 | 10 |
| A[ 88] : | G | C | T | C | C | 01 | 01 | 01 | 11 |
| A[ 89] : | T | G | T | C | C | 01 | 01 | 10 | 00 |
| A[ 90] : | A | G | T | C | C | 01 | 01 | 10 | 01 |
| A[ 91] : | C | G | T | C | C | 01 | 01 | 10 | 10 |
| A[ 92] : | C | G | G | C | C | 01 | 01 | 10 | 11 |
| A[ 93] : | G | T | G | C | C | 01 | 01 | 11 | 00 |
| A[ 94] : | A | T | T | C | C | 01 | 01 | 11 | 01 |
| A[ 95] : | A | T | G | C | C | 01 | 01 | 11 | 10 |
| A[ 96] : | G | T | T | C | C | 01 | 01 | 11 | 11 |
| A[ 97] : | T | A | T | G | C | 01 | 10 | 00 | 00 |
| A[ 98] : | G | A | C | G | C | 01 | 10 | 00 | 01 |
| A[ 99] : | C | A | T | G | C | 01 | 10 | 00 | 10 |
| A[100] : | C | A | T | G | C | 01 | 10 | 00 | 11 |
| A[101] : | T | C | T | G | C | 01 | 10 | 01 | 00 |
| A[102] : | A | C | T | G | C | 01 | 10 | 01 | 01 |
| A[103] : | T | C | C | G | C | 01 | 10 | 01 | 10 |
| A[104] : | G | C | T | G | C | 01 | 10 | 01 | 11 |
| A[105] : | T | G | T | G | C | 01 | 10 | 10 | 00 |
| A[106] : | A | G | T | G | C | 01 | 10 | 10 | 01 |
| A[107] : | C | G | T | G | C | 01 | 10 | 10 | 10 |
| A[108] : | A | G | C | G | C | 01 | 10 | 10 | 11 |
| A[109] : | C | T | C | G | C | 01 | 10 | 11 | 00 |
| A[110] : | G | T | C | G | C | 01 | 10 | 11 | 01 |
| A[111] : | C | T | T | G | C | 01 | 10 | 11 | 10 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[112] : | G | T | T | G | C | 01 | 10 | 11 | 11 |
| A[113] : | G | A | G | T | C | 01 | 11 | 00 | 00 |
| A[114] : | T | A | G | T | C | 01 | 11 | 00 | 01 |
| A[115] : | T | A | C | T | C | 01 | 11 | 00 | 10 |
| A[116] : | C | A | G | T | C | 01 | 11 | 00 | 11 |
| A[117] : | G | C | G | T | C | 01 | 11 | 01 | 00 |
| A[118] : | T | C | G | T | C | 01 | 11 | 01 | 01 |
| A[119] : | A | C | G | T | C | 01 | 11 | 01 | 10 |
| A[120] : | A | C | C | T | C | 01 | 11 | 01 | 11 |
| A[121] : | C | G | C | T | C | 01 | 11 | 10 | 00 |
| A[122] : | T | G | G | T | C | 01 | 11 | 10 | 01 |
| A[123] : | A | G | G | T | C | 01 | 11 | 10 | 10 |
| A[124] : | A | G | C | T | C | 01 | 11 | 10 | 11 |
| A[125] : | G | T | G | T | C | 01 | 11 | 11 | 00 |
| A[126] : | G | T | C | T | C | 01 | 11 | 11 | 01 |
| A[127] : | A | T | G | T | C | 01 | 11 | 11 | 10 |
| A[128] : | C | T | G | T | C | 01 | 11 | 11 | 11 |
| A[129] : | G | A | G | A | G | 10 | 00 | 00 | 00 |
| A[130] : | T | A | G | A | G | 10 | 00 | 00 | 01 |
| A[131] : | C | A | T | A | G | 10 | 00 | 00 | 10 |
| A[132] : | G | A | T | A | G | 10 | 00 | 00 | 11 |
| A[133] : | T | C | T | A | G | 10 | 00 | 01 | 00 |
| A[134] : | T | C | G | A | G | 10 | 00 | 01 | 01 |
| A[135] : | A | C | G | A | G | 10 | 00 | 01 | 10 |
| A[136] : | G | C | T | A | G | 10 | 00 | 01 | 11 |
| A[137] : | T | G | T | A | G | 10 | 00 | 10 | 00 |
| A[138] : | A | G | T | A | G | 10 | 00 | 10 | 01 |
| A[139] : | C | G | T | A | G | 10 | 00 | 10 | 10 |
| A[140] : | C | G | G | A | G | 10 | 00 | 10 | 11 |
| A[141] : | G | T | G | A | G | 10 | 00 | 11 | 00 |
| A[142] : | A | T | T | A | G | 10 | 00 | 11 | 01 |
| A[143] : | C | T | T | A | G | 10 | 00 | 11 | 10 |
| A[144] : | C | T | G | A | G | 10 | 00 | 11 | 11 |
| A[145] : | T | A | T | C | G | 10 | 01 | 00 | 00 |
| A[146] : | T | A | G | C | G | 10 | 01 | 00 | 01 |
| A[147] : | C | A | T | C | G | 10 | 01 | 00 | 10 |
| A[148] : | G | A | T | C | G | 10 | 01 | 00 | 11 |
| A[149] : | T | C | T | C | G | 10 | 01 | 01 | 00 |
| A[150] : | A | C | T | C | G | 10 | 01 | 01 | 01 |
| A[151] : | A | C | G | C | G | 10 | 01 | 01 | 10 |
| A[152] : | G | C | T | C | G | 10 | 01 | 01 | 11 |
| A[153] : | T | G | T | C | G | 10 | 01 | 10 | 00 |
| A[154] : | A | G | T | C | G | 10 | 01 | 10 | 01 |
| A[155] : | C | G | T | C | G | 10 | 01 | 10 | 10 |
| A[156] : | C | G | G | C | G | 10 | 01 | 10 | 11 |
| A[157] : | G | T | G | C | G | 10 | 01 | 11 | 00 |
| A[158] : | A | T | T | C | G | 10 | 01 | 11 | 01 |
| A[159] : | A | T | G | C | G | 10 | 01 | 11 | 10 |
| A[160] : | G | T | T | C | G | 10 | 01 | 11 | 11 |
| A[161] : | T | A | T | G | G | 10 | 10 | 00 | 00 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| A[162] : | G | A | C | G | G | 10 | 10 | 00 | 01 |
| A[163] : | C | A | T | G | G | 10 | 10 | 00 | 10 |
| A[164] : | G | A | T | G | G | 10 | 10 | 00 | 11 |
| A[165] : | T | C | T | G | G | 10 | 10 | 01 | 00 |
| A[166] : | A | C | T | G | G | 10 | 10 | 01 | 01 |
| A[167] : | T | C | C | G | G | 10 | 10 | 01 | 10 |
| A[168] : | G | C | T | G | G | 10 | 10 | 01 | 11 |
| A[169] : | T | G | T | G | G | 10 | 10 | 10 | 00 |
| A[170] : | A | G | T | G | G | 10 | 10 | 10 | 01 |
| A[171] : | C | G | T | G | G | 10 | 10 | 10 | 10 |
| A[172] : | A | G | C | G | G | 10 | 10 | 10 | 11 |
| A[173] : | C | T | C | G | G | 10 | 10 | 11 | 00 |
| A[174] : | G | T | C | G | G | 10 | 10 | 11 | 01 |
| A[175] : | C | T | T | G | G | 10 | 10 | 11 | 10 |
| A[176] : | G | T | T | G | G | 10 | 10 | 11 | 11 |
| A[177] : | G | A | G | T | G | 10 | 11 | 00 | 00 |
| A[178] : | T | A | G | T | G | 10 | 11 | 00 | 01 |
| A[179] : | T | A | C | T | G | 10 | 11 | 00 | 10 |
| A[180] : | C | A | G | T | G | 10 | 11 | 00 | 11 |
| A[181] : | G | C | G | T | G | 10 | 11 | 01 | 00 |
| A[182] : | T | C | G | T | G | 10 | 11 | 01 | 01 |
| A[183] : | A | C | G | T | G | 10 | 11 | 01 | 10 |
| A[184] : | A | C | C | T | G | 10 | 11 | 01 | 11 |
| A[185] : | C | G | C | T | G | 10 | 11 | 10 | 00 |
| A[186] : | T | G | G | T | G | 10 | 11 | 10 | 01 |
| A[187] : | A | G | G | T | G | 10 | 11 | 10 | 10 |
| A[188] : | A | G | C | T | G | 10 | 11 | 10 | 11 |
| A[189] : | G | T | G | T | G | 10 | 11 | 11 | 00 |
| A[190] : | G | T | C | T | G | 10 | 11 | 11 | 01 |
| A[191] : | A | T | G | T | G | 10 | 11 | 11 | 10 |
| A[192] : | C | T | G | T | G | 10 | 11 | 11 | 11 |
| A[193] : | G | A | G | A | T | 11 | 00 | 00 | 00 |
| A[194] : | T | A | G | A | T | 11 | 00 | 00 | 01 |
| A[195] : | C | A | T | A | T | 11 | 00 | 00 | 10 |
| A[196] : | G | A | T | A | T | 11 | 00 | 00 | 11 |
| A[197] : | T | C | T | A | T | 11 | 00 | 01 | 00 |
| A[198] : | T | C | G | A | T | 11 | 00 | 01 | 01 |
| A[199] : | A | C | G | A | T | 11 | 00 | 01 | 10 |
| A[200] : | G | C | T | A | T | 11 | 00 | 01 | 11 |
| A[201] : | T | G | T | A | T | 11 | 00 | 10 | 00 |
| A[202] : | A | G | T | A | T | 11 | 00 | 10 | 01 |
| A[203] : | C | G | T | A | T | 11 | 00 | 10 | 10 |
| A[204] : | C | G | G | A | T | 11 | 00 | 10 | 11 |
| A[205] : | G | T | G | A | T | 11 | 00 | 11 | 00 |
| A[206] : | A | T | T | A | T | 11 | 00 | 11 | 01 |
| A[207] : | C | T | T | A | T | 11 | 00 | 11 | 10 |
| A[208] : | C | T | G | A | T | 11 | 00 | 11 | 11 |
| A[209] : | T | A | T | C | T | 11 | 01 | 00 | 00 |
| A[210] : | T | A | G | C | T | 11 | 01 | 00 | 01 |
| A[211] : | C | A | T | C | T | 11 | 01 | 00 | 10 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| A[212] : | G | A | T | C | T | 11 | 01 | 00 | 11 |
| A[213] : | T | C | T | C | T | 11 | 01 | 01 | 00 |
| A[214] : | A | C | T | C | T | 11 | 01 | 01 | 01 |
| A[215] : | A | C | G | C | T | 11 | 01 | 01 | 10 |
| A[216] : | G | C | T | C | T | 11 | 01 | 01 | 11 |
| A[217] : | T | G | T | C | T | 11 | 01 | 10 | 00 |
| A[218] : | A | G | T | C | T | 11 | 01 | 10 | 01 |
| A[219] : | C | G | T | C | T | 11 | 01 | 10 | 10 |
| A[220] : | C | G | G | C | T | 11 | 01 | 10 | 11 |
| A[221] : | G | T | G | C | T | 11 | 01 | 11 | 00 |
| A[222] : | A | T | T | C | T | 11 | 01 | 11 | 01 |
| A[223] : | A | T | G | C | T | 11 | 01 | 11 | 10 |
| A[224] : | G | T | T | C | T | 11 | 01 | 11 | 11 |
| A[225] : | T | A | T | G | T | 11 | 10 | 00 | 00 |
| A[226] : | G | A | C | G | T | 11 | 10 | 00 | 01 |
| A[227] : | C | A | T | G | T | 11 | 10 | 00 | 10 |
| A[228] : | G | A | T | G | T | 11 | 10 | 00 | 11 |
| A[229] : | T | C | T | G | T | 11 | 10 | 01 | 00 |
| A[230] : | A | C | T | G | T | 11 | 10 | 01 | 01 |
| A[231] : | T | C | C | G | T | 11 | 10 | 01 | 10 |
| A[232] : | G | C | T | G | T | 11 | 10 | 01 | 11 |
| A[233] : | T | G | T | G | T | 11 | 10 | 10 | 00 |
| A[234] : | A | G | T | G | T | 11 | 10 | 10 | 01 |
| A[235] : | C | G | T | G | T | 11 | 10 | 10 | 10 |
| A[236] : | A | G | C | G | T | 11 | 10 | 10 | 11 |
| A[237] : | C | T | C | G | T | 11 | 10 | 11 | 00 |
| A[238] : | G | T | C | G | T | 11 | 10 | 11 | 01 |
| A[239] : | C | T | T | G | T | 11 | 10 | 11 | 10 |
| A[240] : | G | T | T | G | T | 11 | 10 | 11 | 11 |
| A[241] : | G | A | G | T | T | 11 | 11 | 00 | 00 |
| A[242] : | T | A | G | T | T | 11 | 11 | 00 | 01 |
| A[243] : | T | A | C | T | T | 11 | 11 | 00 | 10 |
| A[244] : | C | A | G | T | T | 11 | 11 | 00 | 11 |
| A[245] : | G | C | G | T | T | 11 | 11 | 01 | 00 |
| A[246] : | T | C | G | T | T | 11 | 11 | 01 | 01 |
| A[247] : | A | C | G | T | T | 11 | 11 | 01 | 10 |
| A[248] : | A | C | C | T | T | 11 | 11 | 01 | 11 |
| A[249] : | C | G | C | T | T | 11 | 11 | 10 | 00 |
| A[250] : | T | G | G | T | T | 11 | 11 | 10 | 01 |
| A[251] : | A | G | G | T | T | 11 | 11 | 10 | 10 |
| A[252] : | A | G | C | T | T | 11 | 11 | 10 | 11 |
| A[253] : | G | T | G | T | T | 11 | 11 | 11 | 00 |
| A[254] : | G | T | C | T | T | 11 | 11 | 11 | 01 |
| A[255] : | A | T | G | T | T | 11 | 11 | 11 | 10 |
| A[256] : | C | T | G | T | T | 11 | 11 | 11 | 11 |

**TABLE G**

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| A[ 1] : | T | A | T | A | A | 00 | 00 | 00 | 00 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| valid | | | | | | | | | |
| A[ 2] : | A | A | T | A | A | 00 | 00 | 00 | 01 |
| no AA at start of next symbol | | | | | invalid | | | | |
| A[ 3] : | A | A | G | A | A | 00 | 00 | 00 | 10 |
| no AA at start of next symbol | | | | | invalid | | | | |
| A[ 4] : | A | A | C | A | A | 00 | 00 | 00 | 11 |
| no AA at start of next symbol | | | | | invalid | | | | |
| A[ 5] : | C | C | C | A | A | 00 | 00 | 01 | 00 |
| no C at start of next symbol | | | | | invalid | | | | |
| A[ 6] : | A | C | T | A | A | 00 | 00 | 01 | 01 |
| valid | | | | | | | | | |
| A[ 7] : | C | C | T | A | A | 00 | 00 | 01 | 10 |
| no CC at start of next symbol | | | | | invalid | | | | |
| A[ 8] : | C | C | G | A | A | 00 | 00 | 01 | 11 |
| no CC at start of next symbol | | | | | invalid | | | | |
| A[ 9] : | G | G | G | A | A | 00 | 00 | 10 | 00 |
| no G at start of next Symbol | | | | | invalid | | | | |
| A[ 10] : | G | G | C | A | A | 00 | 00 | 10 | 01 |
| no GG at start of next symbol | | | | | invalid | | | | |
| A[ 11] : | A | G | G | A | A | 00 | 00 | 10 | 10 |
| valid | | | | | | | | | |
| A[ 12] : | G | G | T | A | A | 00 | 00 | 10 | 11 |
| no GG at start of next Symbol | | | | | invalid | | | | |
| A[ 13] : | T | T | T | A | A | 00 | 00 | 11 | 00 |
| no T at start of next Symbol | | | | | invalid | | | | |
| A[ 14] : | T | T | G | A | A | 00 | 00 | 11 | 01 |
| no TT at start of next Symbol | | | | | invalid | | | | |
| A[ 15] : | T | T | C | A | A | 00 | 00 | 11 | 10 |
| no TT at start of next Symbol | | | | | invalid | | | | |
| A[ 16] : | G | T | T | A | A | 00 | 00 | 11 | 11 |
| valid | | | | | | | | | |
| A[ 17] : | C | A | C | C | A | 00 | 01 | 00 | 00 |
| valid | | | | | | | | | |
| A[ 18] : | G | A | C | C | A | 00 | 01 | 00 | 01 |
| valid | | | | | | | | | |
| A[ 19] : | T | A | C | C | A | 00 | 01 | 00 | 10 |
| valid | | | | | | | | | |
| A[ 20] : | T | A | A | C | A | 00 | 01 | 00 | 11 |
| valid | | | | | | | | | |
| A[ 21] : | A | C | A | C | A | 00 | 01 | 01 | 00 |
| valid | | | | | | | | | |
| A[ 22] : | G | C | C | C | A | 00 | 01 | 01 | 01 |
| valid | | | | | | | | | |
| A[ 23] : | T | C | C | C | A | 00 | 01 | 01 | 10 |
| valid | | | | | | | | | |
| A[ 24] : | A | C | C | C | A | 00 | 01 | 01 | 11 |
| valid | | | | | | | | | |
| A[ 25] : | C | G | C | C | A | 00 | 01 | 10 | 00 |
| valid | | | | | | | | | |
| A[ 26] : | T | G | G | C | A | 00 | 01 | 10 | 01 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| valid A[ 27] : | T | G | C | C | A | 00 | 01 | 10 | 10 |
| valid A[ 28] : | A | G | C | C | A | 00 | 01 | 10 | 11 |
| valid A[ 29] : | C | T | C | C | A | 00 | 01 | 11 | 00 |
| valid A[ 30] : | G | T | C | C | A | 00 | 01 | 11 | 01 |
| valid A[ 31] : | C | T | T | C | A | 00 | 01 | 11 | 10 |
| valid A[ 32] : | A | T | C | C | A | 00 | 01 | 11 | 11 |
| valid A[ 33] : | G | A | G | G | A | 00 | 10 | 00 | 00 |
| valid A[ 34] : | T | A | G | G | A | 00 | 10 | 00 | 01 |
| valid A[ 35] : | G | A | A | G | A | 00 | 10 | 00 | 10 |
| valid A[ 36] : | C | A | G | G | A | 00 | 10 | 00 | 11 |
| valid A[ 37] : | G | C | G | G | A | 00 | 10 | 01 | 00 |
| valid A[ 38] : | T | C | G | G | A | 00 | 10 | 01 | 01 |
| valid A[ 39] : | A | C | G | G | A | 00 | 10 | 01 | 10 |
| valid A[40] : | A | C | C | G | A | 00 | 10 | 01 | 11 |
| valid A[ 41] : | A | G | A | | A | 00 | 10 | 10 | 00 |
| valid A[ 42] : | T | G | G | G | A | 00 | 10 | 10 | 01 |
| valid A[ 43] : | A | G | G | G | A | 00 | 10 | 10 | 10 |
| valid A[ 44] : | C | G | G | G | A | 00 | 10 | 10 | 11 |
| valid A[ 45] : | G | T | G | G | A | 00 | 10 | 11 | 00 |
| valid A[ 46] : | A | T | T | G | A | 00 | 10 | 11 | 01 |
| valid A[ 47] : | A | T | G | G | A | 00 | 10 | 11 | 10 |
| valid A[ 48] : | C | T | G | G | A | 00 | 10 | 11 | 11 |
| valid A[ 49] : | T | A | T | T | A | 00 | 11 | 00 | 00 |
| valid A[ 50] : | C | A | A | T | A | 00 | 11 | 00 | 01 |
| valid A[ 51] : | C | A | T | T | A | 00 | 11 | 00 | 10 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| valid A[ 52] : | G | A | T | T | A | 00 | 11 | 00 | 11 |
| valid A[ 53] : | T | C | T | T | A | 00 | 11 | 01 | 00 |
| valid A[ 54] : | A | C | T | T | A | 00 | 11 | 01 | 01 |
| valid A[ 55] : | T | C | C | T | A | 00 | 11 | 01 | 10 |
| valid A[ 56] : | G | C | T | T | A | 00 | 11 | 01 | 11 |
| valid A[ 57] : | T | G | T | T | A | 00 | 11 | 10 | 00 |
| valid A[ 58] : | A | G | T | T | A | 00 | 11 | 10 | 01 |
| valid A[ 59] : | C | G | T | T | A | 00 | 11 | 10 | 10 |
| valid A[ 60] : | C | G | G | T | A | 00 | 11 | 10 | 11 |
| valid A[ 61] : | A | T | A | T | A | 00 | 11 | 11 | 00 |
| valid A[ 62] : | A | T | T | T | A | 00 | 11 | 11 | 01 |
| valid A[ 63] : | C | T | T | T | A | 00 | 11 | 11 | 10 |
| valid A[ 64] : | G | T | T | T | A | 00 | 11 | 11 | 11 |
| valid A[ 65] : | T | A | T | A | C | 01 | 00 | 00 | 00 |
| valid A[ 66] : | C | A | A | A | C | 01 | 00 | 00 | 01 |
| valid A[ 67] : | G | A | A | A | C | 01 | 00 | 00 | 10 |
| valid A[ 68] : | T | A | A | A | C | 01 | 00 | 00 | 11 |
| valid A[ 69] : | A | C | A | A | C | 01 | 00 | 01 | 00 |
| valid A[ 70] : | A | C | T | A | C | 01 | 00 | 01 | 01 |
| valid A[ 71] : | G | C | A | A | C | 01 | 00 | 01 | 10 |
| valid A[ 72] : | T | C | A | A | C | 01 | 00 | 01 | 11 |
| valid A[ 73] : | A | G | A | A | C | 01 | 00 | 10 | 00 |
| valid A[ 74] : | C | G | A | A | C | 01 | 00 | 10 | 01 |
| valid A[ 75] : | A | G | G | A | C | 01 | 00 | 10 | 10 |
| valid A[ 76] : | T | G | A | A | C | 01 | 00 | 10 | 11 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| valid | | | | | | | | | |
| A[ 77] : | A | T | A | A | C | 01 | 00 | 11 | 00 |
| valid | | | | | | | | | |
| A[ 78] : | C | T | A | A | C | 01 | 00 | 11 | 01 |
| valid | | | | | | | | | |
| A[ 79] : | G | T | A | A | C | 01 | 00 | 11 | 10 |
| valid | | | | | | | | | |
| A[ 80] : | G | T | T | A | C | 01 | 00 | 11 | 11 |
| valid | | | | | | | | | |
| A[ 81] : | A | A | A | C | C | 01 | 01 | 00 | 00 |
| no A at start of next symbol | | | | invalid | | | | | |
| A[ 82] : | A | A | T | C | C | 01 | 01 | 00 | 01 |
| no AA at start of next symbol | | | | invalid | | | | | |
| A[ 83] : | A | A | G | C | C | 01 | 01 | 00 | 10 |
| no AA at start of next symbol | | | | invalid | | | | | |
| A[ 84] : | T | A | A | C | C | 01 | 01 | 00 | 11 |
| valid | | | | | | | | | |
| A[ 85] : | A | C | A | C | C | 01 | 01 | 01 | 00 |
| valid | | | | | | | | | |
| A[ 86] : | C | C | A | C | C | 01 | 01 | 01 | 01 |
| no CC at start of next symbol | | | | invalid | | | | | |
| A[ 87] : | C | C | T | C | C | 01 | 01 | 01 | 10 |
| no CC at start of next symbol | | | | invalid | | | | | |
| A[ 88] : | C | C | G | C | C | 01 | 01 | 01 | 11 |
| no CC at start of next symbol | | | | invalid | | | | | |
| A[ 89] : | G | G | G | C | C | 01 | 01 | 10 | 00 |
| no G at start of next symbol | | | | invalid | | | | | |
| A[ 90] : | T | G | G | C | C | 01 | 01 | 10 | 01 |
| valid | | | | | | | | | |
| A[ 91] : | G | G | A | C | C | 01 | 01 | 10 | 10 |
| no GG at start of next symbol | | | | invalid | | | | | |
| A[ 92] : | G | G | T | C | C | 01 | 01 | 10 | 11 |
| no GG at start of next symbol | | | | invalid | | | | | |
| A[ 93] : | T | T | T | C | C | 01 | 01 | 11 | 00 |
| no T at start of next symbol | | | | invalid | | | | | |
| A[ 94] : | T | T | G | C | C | 01 | 01 | 11 | 01 |
| no TT at start of next symbol | | | | invalid | | | | | |
| A[ 95] : | C | T | T | C | C | 01 | 01 | 11 | 10 |
| valid | | | | | | | | | |
| A[ 96] : | T | T | A | C | C | 01 | 01 | 11 | 11 |
| no TT at start of next symbol | | | | invalid | | | | | |
| A[ 97] : | G | A | G | G | C | 01 | 10 | 00 | 00 |
| valid | | | | | | | | | |
| A[ 98] : | T | A | G | G | C | 01 | 10 | 00 | 01 |
| valid | | | | | | | | | |
| A[ 99] : | G | A | A | G | C | 01 | 10 | 00 | 10 |
| valid | | | | | | | | | |
| A[100] : | C | A | G | G | C | 01 | 10 | 00 | 11 |
| valid | | | | | | | | | |
| A[101] : | G | C | G | G | C | 01 | 10 | 01 | 00 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| valid A[102] : | T | C | G | G | C | 01 | 10 | 01 | 01 |
| valid A[103] : | A | C | G | G | C | 01 | 10 | 01 | 10 |
| valid A[104] : | A | C | C | G | C | 01 | 10 | 01 | 11 |
| valid A[105] : | A | G | A | G | C | 01 | 10 | 10 | 00 |
| valid A[106] : | T | G | G | G | C | 01 | 10 | 10 | 01 |
| valid A[107] : | A | G | G | G | C | 01 | 10 | 10 | 10 |
| valid A[108] : | C | G | G | G | C | 01 | 10 | 10 | 11 |
| valid A[109] : | G | T | G | G | C | 01 | 10 | 11 | 00 |
| valid A[110] : | A | T | T | G | C | 01 | 10 | 11 | 01 |
| valid A[111] : | A | T | G | G | C | 01 | 10 | 11 | 10 |
| valid A[112] : | C | T | G | G | C | 01 | 10 | 11 | 11 |
| valid A[113] : | T | A | T | T | C | 01 | 11 | 00 | 00 |
| valid A[114] : | C | A | A | T | C | 01 | 11 | 00 | 01 |
| valid A[115] : | C | A | T | T | C | 01 | 11 | 00 | 10 |
| valid A[116] : | G | A | T | T | C | 01 | 11 | 00 | 11 |
| valid A[117] : | T | C | T | T | C | 01 | 11 | 01 | 00 |
| valid A[118] : | A | C | T | T | C | 01 | 11 | 01 | 01 |
| valid A[119] : | T | C | C | T | C | 01 | 11 | 01 | 10 |
| valid A[120] : | G | C | T | T | C | 01 | 11 | 01 | 11 |
| valid A[121] : | T | G | T | T | C | 01 | 11 | 10 | 00 |
| valid A[122] : | A | G | T | T | C | 01 | 11 | 10 | 01 |
| valid A[123] : | C | G | T | T | C | 01 | 11 | 10 | 10 |
| valid A[124] : | C | G | G | T | C | 01 | 11 | 10 | 11 |
| valid A[125] : | A | T | A | T | C | 01 | 11 | 11 | 00 |
| valid A[126] : | A | T | T | T | C | 01 | 11 | 11 | 01 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| valid A[127] : | C | T | T | T | C | 01 | 11 | 11 | 10 |
| valid A[128] : | G | T | T | T | C | 01 | 11 | 11 | 11 |
| valid A[129] : | T | A | T | A | G | 10 | 00 | 00 | 00 |
| valid A[130] : | C | A | A | A | G | 10 | 00 | 00 | 01 |
| valid A[131] : | G | A | A | A | G | 10 | 00 | 00 | 10 |
| valid A[132] : | T | A | A | A | G | 10 | 00 | 00 | 11 |
| valid A[133] : | A | C | A | A | G | 10 | 00 | 01 | 00 |
| valid A[134] : | A | C | T | A | G | 10 | 00 | 01 | 01 |
| valid A[135] : | G | C | A | A | G | 10 | 00 | 01 | 10 |
| valid A[136] : | T | C | A | A | G | 10 | 00 | 01 | 11 |
| valid A[137] : | A | G | A | A | G | 10 | 00 | 10 | 00 |
| valid A[138] : | C | G | A | A | G | 10 | 00 | 10 | 01 |
| valid A[139] : | A | G | G | A | G | 10 | 00 | 10 | 10 |
| valid A[140] : | T | G | A | A | G | 10 | 00 | 10 | 11 |
| valid A[141] : | A | T | A | A | G | 10 | 00 | 11 | 00 |
| valid A[142] : | C | T | A | A | G | 10 | 00 | 11 | 01 |
| valid A[143] : | G | T | A | A | G | 10 | 00 | 11 | 10 |
| valid A[144] : | G | T | T | A | G | 10 | 00 | 11 | 11 |
| valid A[145] : | C | A | C | C | G | 10 | 01 | 00 | 00 |
| valid A[146] : | G | A | C | C | G | 10 | 01 | 00 | 01 |
| valid A[147] : | T | A | C | C | G | 10 | 01 | 00 | 10 |
| valid A[148] : | T | A | A | C | G | 10 | 01 | 00 | 11 |
| valid A[149] : | A | C | A | C | G | 10 | 01 | 01 | 00 |
| valid A[150] : | G | C | C | C | G | 10 | 01 | 01 | 01 |
| valid A[151] : | T | C | C | C | G | 10 | 01 | 01 | 10 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ | Validity |
|---|---|---|---|---|---|---|---|---|---|---|
| A[152] : | A | C | C | C | G | 10 | 01 | 01 | 11 | valid |
| A[153] : | C | G | C | C | G | 10 | 01 | 10 | 00 | valid |
| A[154] : | T | G | G | C | G | 10 | 01 | 10 | 01 | valid |
| A[155] : | T | G | C | C | G | 10 | 01 | 10 | 10 | valid |
| A[156] : | A | G | C | C | G | 10 | 01 | 10 | 11 | valid |
| A[157] : | C | T | C | C | G | 10 | 01 | 11 | 00 | valid |
| A[158] : | G | T | C | C | G | 10 | 01 | 11 | 01 | valid |
| A[159] : | C | T | T | C | G | 10 | 01 | 11 | 10 | valid |
| A[160] : | A | T | C | C | G | 10 | 01 | 11 | 11 | valid |
| A[161] : | A | A | A | G | G | 10 | 10 | 00 | 00 | no A at start of next symbol — invalid |
| A[162] : | A | A | T | G | G | 10 | 10 | 00 | 01 | no AA at start of next symbol — invalid |
| A[163] : | G | A | A | G | G | 10 | 10 | 00 | 10 | valid |
| A[164] : | A | A | C | G | G | 10 | 10 | 00 | 11 | no AA at start of next symbol — invalid |
| A[165] : | C | C | C | G | G | 10 | 10 | 01 | 00 | no C at start of next symbol — invalid |
| A[166] : | C | C | A | G | G | 10 | 10 | 01 | 01 | no CC at start of next symbol — invalid |
| A[167] : | C | C | T | G | G | 10 | 10 | 01 | 10 | no CC at start of next symbol — invalid |
| A[168] : | A | C | C | G | G | 10 | 10 | 01 | 11 | valid |
| A[169] : | A | G | A | G | G | 10 | 10 | 10 | 00 | valid |
| A[170] : | G | G | C | G | G | 10 | 10 | 10 | 01 | no GG at start of next symbol — invalid |
| A[171] : | G | G | A | G | G | 10 | 10 | 10 | 10 | no GG at start of next symbol — invalid |
| A[172] : | G | G | T | G | G | 10 | 10 | 10 | 11 | no GG at start of next symbol — invalid |
| A[173] : | T | T | T | G | G | 10 | 10 | 11 | 00 | no T at start of next symbol — invalid |
| A[174] : | A | T | T | G | G | 10 | 10 | 11 | 01 | valid |
| A[175] : | T | T | C | G | G | 10 | 10 | 11 | 10 | no TT at start of next symbol — invalid |
| A[176] : | T | T | A | G | G | 10 | 10 | 11 | 11 | |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| no TT at start of next symbol | | | | | invalid | | | | |
| A[177] : valid | T | A | T | T | G | 10 | 11 | 00 | 00 |
| A[178] : valid | C | A | A | T | G | 10 | 11 | 00 | 01 |
| A[179] : valid | C | A | T | T | G | 10 | 11 | 00 | 10 |
| A[180] : valid | G | A | T | T | G | 10 | 11 | 00 | 11 |
| A[181] : valid | T | C | T | T | G | 10 | 11 | 01 | 00 |
| A[182] : valid | A | C | T | T | G | 10 | 11 | 01 | 01 |
| A[183] : valid | T | C | C | T | G | 10 | 11 | 01 | 10 |
| A[184] : valid | G | C | T | T | G | 10 | 11 | 01 | 11 |
| A[185] : valid | T | G | T | T | G | 10 | 11 | 10 | 00 |
| A[186] : valid | A | G | T | T | G | 10 | 11 | 10 | 01 |
| A[187] : valid | C | G | T | T | G | 10 | 11 | 10 | 10 |
| A[188] : valid | C | G | G | T | G | 10 | 11 | 10 | 11 |
| A[189] : valid | A | T | A | T | G | 10 | 11 | 11 | 00 |
| A[190] : valid | A | T | T | T | G | 10 | 11 | 11 | 01 |
| A[191] : valid | C | T | T | T | G | 10 | 11 | 11 | 10 |
| A[192] : valid | G | T | T | T | G | 10 | 11 | 11 | 11 |
| A[193] : valid | T | A | T | A | T | 11 | 00 | 00 | 00 |
| A[194] : valid | C | A | A | A | T | 11 | 00 | 00 | 01 |
| A[195] : valid | G | A | A | A | T | 11 | 00 | 00 | 10 |
| A[196] : valid | T | A | A | A | T | 11 | 00 | 00 | 11 |
| A[197] : valid | A | C | A | A | T | 11 | 00 | 01 | 00 |
| A[198] : valid | A | C | T | A | T | 11 | 00 | 01 | 01 |
| A[199] : valid | G | C | A | A | T | 11 | 00 | 01 | 10 |
| A[200] : valid | T | C | A | A | T | 11 | 00 | 01 | 11 |
| A[201] : | A | G | A | A | T | 11 | 00 | 10 | 00 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| valid A[202] : | C | G | A | A | T | 11 | 00 | 10 | 01 |
| valid A[203] : | A | G | G | A | T | 11 | 00 | 10 | 10 |
| valid A[204] : | T | G | A | A | T | 11 | 00 | 10 | 11 |
| valid A[205] : | A | T | A | A | T | 11 | 00 | 11 | 00 |
| valid A[206] : | C | T | A | A | T | 11 | 00 | 11 | 01 |
| valid A[207] : | G | T | A | A | T | 11 | 00 | 11 | 10 |
| valid A[208] : | G | T | T | A | T | 11 | 00 | 11 | 11 |
| valid A[209] : | C | A | C | C | T | 11 | 01 | 00 | 00 |
| valid A[210] : | G | A | C | C | T | 11 | 01 | 00 | 01 |
| valid A[211] : | T | A | C | C | T | 11 | 01 | 00 | 10 |
| valid A[212] : | T | A | A | C | T | 11 | 01 | 00 | 11 |
| valid A[213] : | A | C | A | C | T | 11 | 01 | 01 | 00 |
| valid A[214] : | G | C | C | C | T | 11 | 01 | 01 | 01 |
| valid A[215] : | T | C | C | C | T | 11 | 01 | 01 | 10 |
| valid A[216] : | A | C | C | C | T | 11 | 01 | 01 | 11 |
| valid A[217] : | C | G | C | C | T | 11 | 01 | 10 | 00 |
| valid A[218] : | T | G | G | C | T | 11 | 01 | 10 | 01 |
| valid A[219] : | T | G | C | C | T | 11 | 01 | 10 | 10 |
| valid A[220] : | A | G | C | C | T | 11 | 01 | 10 | 11 |
| valid A[221] : | C | T | C | C | T | 11 | 01 | 11 | 00 |
| valid A[222] : | G | T | C | C | T | 11 | 01 | 11 | 01 |
| valid A[223] : | C | T | T | C | T | 11 | 01 | 11 | 10 |
| valid A[224] : | A | T | C | C | T | 11 | 01 | 11 | 11 |
| valid A[225] : | G | A | G | G | T | 11 | 10 | 00 | 00 |
| valid A[226] : | T | A | G | G | T | 11 | 10 | 00 | 01 |

(continued)

| Index | nt$_0$ | nt$_1$ | nt$_2$ | nt$_3$ | nt$_4$ | (b$_0$, b$_1$) | (b$_2$, b$_3$) | (b$_4$, b$_5$) | (b$_6$, b$_7$) |
|---|---|---|---|---|---|---|---|---|---|
| valid A[227] : | G | A | A | G | T | 11 | 10 | 00 | 10 |
| valid A[228] : | C | A | G | G | T | 11 | 10 | 00 | 11 |
| valid A[229] : | G | C | G | G | T | 11 | 10 | 01 | 00 |
| valid A[230] : | T | C | G | G | T | 11 | 10 | 01 | 01 |
| invalid A[231] : | A | C | G | G | T | 11 | 10 | 01 | 10 |
| invalid A[232] : | A | C | C | G | T | 11 | 10 | 01 | 11 |
| valid A[233] : | A | G | A | G | T | 11 | 10 | 10 | 00 |
| valid A[234] : | T | G | G | G | T | 11 | 10 | 10 | 01 |
| valid A[235] : | A | G | G | G | T | 11 | 10 | 10 | 10 |
| valid A[236] : | C | G | G | G | T | 11 | 10 | 10 | 11 |
| valid A[237] : | G | T | G | G | T | 11 | 10 | 11 | 00 |
| valid A[238] : | A | T | T | G | T | 11 | 10 | 11 | 01 |
| valid A[239] : | A | T | G | G | T | 11 | 10 | 11 | 10 |
| valid A[240] : | C | T | G | G | T | 11 | 10 | 11 | 11 |
| valid A[241] : | A | A | A | T | T | 11 | 11 | 00 | 00 |
| no A at start of next symbol | | | | invalid | | | | | |
| A[242] : | C | A | A | T | T | 11 | 11 | 00 | 01 |
| valid A[243] : | A | A | G | T | T | 11 | 11 | 00 | 10 |
| no AA at start of next symbol | | | | invalid | | | | | |
| A[244] : | A | A | C | T | T | 11 | 11 | 00 | 11 |
| no AA at start of next symbol | | | | invalid | | | | | |
| A[245] : | C | C | C | T | T | 11 | 11 | 01 | 00 |
| no C at start of next symbol | | | | invalid | | | | | |
| A[246] : | C | C | A | T | T | 11 | 11 | 01 | 01 |
| no CC at start of next symbol | | | | invalid | | | | | |
| A[247] : | T | C | C | T | T | 11 | 11 | 01 | 10 |
| valid A[248] : | C | C | G | T | T | 11 | 11 | 01 | 11 |
| no CC at start of next symbol | | | | invalid | | | | | |
| A[249] : | G | G | G | T | T | 11 | 11 | 10 | 00 |
| no G at start of next symbol | | | | invalid | | | | | |
| A[250] : | G | G | C | T | T | 11 | 11 | 10 | 01 |
| no GG at start of next symbol | | | | invalid | | | | | |
| A[251] : | G | G | A | T | T | 11 | 11 | 10 | 10 |

(continued)

| Index | $nt_0$ | $nt_1$ | $nt_2$ | $nt_3$ | $nt_4$ | $(b_0, b_1)$ | $(b_2, b_3)$ | $(b_4, b_5)$ | $(b_6, b_7)$ |
|---|---|---|---|---|---|---|---|---|---|
| no GG at start of next symbol | | | | | invalid | | | | |
| A[252] : | C | G | G | T | T | 11 | 11 | 10 | 11 |
| valid | | | | | | | | | |
| A[253] : | A | T | A | T | T | 11 | 11 | 11 | 00 |
| valid | | | | | | | | | |
| A[254] : | T | T | G | T | T | 11 | 11 | 11 | 01 |
| no TT at start of next symbol | | | | | invalid | | | | |
| A[255] : | T | T | C | T | T | 11 | 11 | 11 | 10 |
| no TT at start of next symbol | | | | | invalid | | | | |
| A[256] : | T | T | A | T | T | 11 | 11 | 11 | 11 |
| no TT at start of next symbol | | | | | invalid | | | | |

**Claims**

1.  Method (30) for generating codes for nucleic acid storage, **comprising**

    - providing (31) a plurality of information units of a first predefined length, the plurality of information units comprising a first amount of information units;
    - providing (32) a plurality of quaternary code words of a second predefined length, the plurality of quaternary code words comprising a second amount of code words, wherein the second amount is at least twice as high as the first amount and the plurality of quaternary code words comprises no code word where the last three code symbols are identical and no code word where the first two code symbols are identical;
    - distributing (33) the plurality of code words to at least a first code and a second code; and
    - mapping (35) said information units at least to the code words of the first code and of the second code.

2.  Method according to claim 1, **wherein** the second predefined length is set to equal 5 quaternary code symbols; and the providing (32) of a plurality of quaternary code words comprises providing only different code words of the second predefined length where the second code symbol, the fourth code symbol and the fifth code symbol are set to assume any quaternary value and the first code symbol and the third code symbol are selected such that no code word is provided where the last three code symbols are identical and no code word is provided where the first two code symbols are identical.

3.  Method according to claim 2, **wherein** the plurality of quaternary code words is provided (32) by generating code words where the fourth code symbol and the fifth code symbol are repeatedly set to assume all possible value combinations until twice the first amount of code words is generated, wherein the second code symbol is repeatedly set to assume all possible values, and the first code symbol and the third code symbol are selected from a table comprising 16 different value combinations of the first and the third code symbol.

4.  Method according to claim 3, **wherein** said table is given by:

| $b_6$ | $b_7$ | $nt_0$ | $nt_2$ | $nt_0$ | $nt_2$ | $nt_0$ | $nt_2$ | $nt_0$ | $nt_2$ |
|---|---|---|---|---|---|---|---|---|---|
| 0 | 0 | A | A | C | C | G | G | T | T |
| 0 | 1 | A | C | C | G | G | T | T | A |
| 1 | 0 | A | G | C | T | G | A | T | C |
| 1 | 1 | A | T | C | A | G | C | T | G |

wherein $nt_0$ and $nt_2$ refer to the first and the third code symbol, A, C, G and T refer to quaternary code symbols, $b_6$ and $b_7$ refer to the seventh and the eighth bit of a byte of an information unit.

**5.** Method according to one of the preceding claims, **further comprising**

- distributing (34) remaining code words not assigned to the first code or to the second code to a third code and
- mapping (36) at least a subset of said information units to the code words of said third code.

**6.** Device (40) for generating code word sequences for nucleic acid storage channel modulation, **comprising**

- a code generator unit (42) configured to generate at least a first code book (43) and a second code book (44), the first code book (43) and the second code book (44) comprising a complete mapping of a plurality of information units of a first predefined length to corresponding quaternary code words of a second predefined length of the first code book (43) and of the second code book (44), wherein
none of the code words belongs to the first and also to the second code book,
none of the code books comprises a code word where the last three code symbols are identical, and
none of the code books comprises a code word where the first two code symbols are identical; and
- a code word sequence generator unit (45) configured to receive user data encoded using the plurality of information units,
to map the information units encoding the user data to corresponding code words selected from at least one of the first code book (43) and the second code book (44), and
to generate at least one code word sequence by concatenating said selected corresponding code words.

**7.** Device according to claim 6, **comprising** a synthesizer unit (46) configured to synthesize at least one nucleic acid molecule containing a segment wherein a sequence of nucleotides is arranged to correspond to the at least one code word sequence.

**8.** Device according to claim 6 or claim 7, **wherein** the code word sequence generator unit (45) is configured to map the information units encoding the user data to corresponding code words alternately selected from the first code book (43) and the second code book (44).

**9.** Device according to one of claims 6 to 8, **wherein** the code word sequence generator unit (45) is configured to remove a most recently appended code word from said at least one code word sequence and append the corresponding code word of the other of the first code book (43) and the second code book (44), if said at least one code word sequence comprises a self-reverse complementary section having a length of at least twice the second predefined length.

**10.** Device according to one of claims 6 to 9, **wherein**
the code word generator unit (42) is configured to additionally generate at least a third code book (48), the third code book (48) comprising a mapping of at least a subset of the plurality of information units to corresponding code words of the third code book (48), wherein
none of the code words of the third code book (48) belongs to the first and the second code book,
the third code book (48) does not comprise a code word where the last three code symbols are identical, and
the third code book (48) does not comprise a code word where the first two code symbols are identical.

**11.** Device according to claim 10, **wherein**
the code word sequence generator unit (45) is further configured to remove the most recently appended code word from said at least one code word sequence and append the corresponding code word of the third code book (48), if said at least one code word sequence comprises a self-reverse complementary section having a length of at least twice the second predefined length, after replacing the most recently appended code word by the corresponding code word of the first code book (43) or of the second code book (44) the at least one code word sequence still comprises such a section and said third code book (48) comprises a corresponding code word.

**12.** Computer readable storage medium having stored therein instructions enabling generation of codes for nucleic acid storage, which, when executed by a computer, cause the computer to:

- provide (31) a plurality of information units of a first predefined length, the plurality of information units comprising a first amount of information units;

- provide (32) a plurality of quaternary code words of a second predefined length, the plurality of quaternary code words comprising a second amount of code words, wherein the second amount is at least twice as high as the first amount and the plurality of quaternary code words comprises no code word where the last three code symbols are identical and no code word where the first two code symbols are identical;
- distribute (33) the plurality of code words to at least a first code and a second code; and
- map (35) said information units at least to the code words of the first code and of the second code.

13. Computer readable storage medium according to claim 12, further having stored therein instructions, which, when executed by a computer, cause the computer to:

- set the second predefined length to equal 5 quaternary code symbols; and
- provide only different code words of the second predefined length where the second code symbol, the fourth code symbol and the fifth code symbol are set to assume any quaternary value and the first code symbol and the third code symbol are selected such that no code word is provided where the last three code symbols are identical and no code word is provided where the first two code symbols are identical.

14. Computer readable storage medium according to claim 13, further having stored therein instructions, which, when executed by a computer, cause the computer to:

- generate the plurality of quaternary code words by generating code words where the fourth code symbol and the fifth code symbol are repeatedly set to assume all possible value combinations until twice the first amount of code words is generated, wherein the second code symbol is repeatedly set to assume all possible values, and the first code symbol and the third code symbol are selected from a table comprising 16 different value combinations of the first and the third code symbol.

10

13

⑤ 5

③ 3

11

12

③ 3

⑤ 5

14

# Fig. 1

22

21

23

# Fig. 2

30

31

Provide information units

32

Provide quaternary code words according to channel modulation scheme

33

Distribute valid code words to first and second code

34

Distribute remaining valid code words to third code

35

Map information units to code words of first and second code

36

Map at least some of the information units to code words of the third code

**Fig. 3**

40

41

42

48

Code generator unit

| Code 1 | Code 2 | | Code 3 |
|--------|--------|--|--------|

43

44

45

Code sequence generator unit

46

Synthesizer unit

47

# Fig. 4

Europäisches
Patentamt

European
Patent Office

Office européen
des brevets

## EUROPEAN SEARCH REPORT

Application Number

EP 14 30 6271

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | P. A. Franaszek: "Sequence-state Methods for Run-length-limited Coding", IBM J. RES. DEVELOP internet article, 1970, XP002738616, Retrieved from the Internet: URL:http://citeseerx.ist.psu.edu/viewdoc/download?doi=10.1.1.89.4691&rep=rep1&type=pdf [retrieved on 2015-04-17] * the whole document * | 1-14 | INV. H03M5/14 |

-----

TECHNICAL FIELDS
SEARCHED    (IPC)

H03M

The present search report has been drawn up for all claims

| Place of search | Date of completion of the search | Examiner |
|---|---|---|
| The Hague | 17 April 2015 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHURCH et al.** Next-generation digital information storage. *Science,* 2012, vol. 337, 1628

- **GOLDMAN et al.** Towards practical, high-capacity, low-maintenance information storage in synthesized DNA. *Nature,* 2013, vol. 494